# EUROPEAN PATENT SPECIFICATION

(11) **EP 1 790 492 B1**
(45) Date of publication and mention of the grant of the patent: **10.09.2008**
(21) Application number: 06024517.2
(22) Date of filing: 27.11.2006
(51) Int. Cl.: B41N 6/00

(54) **Infrared sensitive planographic printing plate precursor**
Infrarot empfindlicher Flachdruckplattenvorläufer
Précurseur de plaque lithographique sensible à l'infrarouge

(30) Priority: 28.11.2005 JP 2005342902
(43) Date of publication of application: 30.05.2007
(73) Proprietor: Fujifilm Corporation, Minato-ku Tokyo (JP)
(72) Inventor: Nagashima, Akira, Haibara-gun Shizuoka-ken (JP)
(74) Representative: HOFFMANN EITLE

(56) References cited:
- EP-A- 1 217 447
- EP-A2- 1 167 063
- EP-A2- 1 239 328

## Description

### BACKGROUND OF THE INVENTION

### Field of the Invention

The present invention relates to an infrared sensitive planographic printing plate precursor. More particularly, the present invention relate to an infrared sensitive planographic printing plate precursor excellent in scratch resistance.

### Description of the Related art

Laser technology has made remarkable progress in recent years. In particular, high-power and compact solid lasers, semiconductor lasers and the like, having an emission wavelength within the near infrared and infrared regions are now readily available. In a planographic printing field, such lasers are advantageously used as light sources for exposing planographic printing precursors so as to produce printing plates directly according to digital data from a computer or the like.

A recording layer of such a positive planographic printing plate precursor for direct plate-making using infrared laser includes as essential components an alkali-soluble resin and an infrared absorbent which absorbs light and generates heat. In unexposed portions (i.e., an image area), the infrared absorbent acts as a dissolution inhibitor, which interacts with the alkali-soluble resin to substantially lower the solubility of the alkali-soluble resin. On the other hand, in exposed portions (i.e., a non-image area), the interaction of the infrared absorbent and the alkali-soluble resin becomes weak due to the heat generated, and the infrared absorbent dissolves in the alkaline developer to form an image. Such a positive planographic printing plate precursor, however, has problems in that the mechanical strength of the recording layer is insufficient. During manufacture, transportation and handling of the printing plate precursor, if the printing surface contacts other components heavily, defects in the printing surface can be generated, and missing portions can appear in the developed image area.

To reduce such problems, planographic printing plate precursors are usually packaged with interleaf sheets interposed between adjacent printing plate precursors. The interleaf sheets, however, have problems of cost and removal. Accordingly, "interleaf sheet-less" is desirable. Recently, as Computer-to-plate (CTP) systems become common, more and more exposure devices are provided with printing plate autoloaders. Such autoloaders, however, have the problem that the interleaf sheets need to be removed in advance from the stack through a bothersome manual operation, and that, even in an autoloader equipped with a device for automatically removing interleaf sheets, the printing plate precursors sometimes become scratched when removing the interleaf sheets. To avoid these problems, demand for planographic printing plate precursors stacked without interleaf sheets is increasing.

A known technique towards packaging without interleaf sheets is to provide supports with a back surface designed to reduce mechanical damage to photosensitive layers caused by contact between the photosensitive layers and the back surface of the supports.

For example, a recording material for offset printing which includes a radiation-sensitive layer and an organic polymer-containing backcoat layer is known. The recording material is provided with a backcoat consisting of an organic polymer having a glass transition temperature of not lower than 35°C, with a pigment such as silica gel contained therein (see Japanese Patent Application Laid-Open (JP-A) No. 2002-46363 corresponding to EP-A2-1167063). The patent document describes that, with this configuration, planographic printing plate precursors can be stacked with no interleaf sheets interposed.

JP-A No. 2003-63162 describes that stacking without a interleaf sheet becomes possible by providing a mat on a surface opposite to a photosensitive layer by electrostatic spraying.

In addition, JP-A No. 2005-62456 describes a photosensitive planographic printing plate characterized in that a covering layer comprising at least one kind resin selected from a group consisting of a saturated copolymer polyester resin, a phenoxy resin, a polyvinyl acetal resin and a vinylidene chloride copolymer resin having a glass transition temperature of 60°C or higher is provided on a surface opposite to a photosensitive layer.

However, when an inorganic pigment such as silica gel is contained in a back coating layer, it was observed that since the hardness of an inorganic pigment is high, a scratch is easily generated on a photosensitive layer due to rubbing when products which have been packaged in stack without using interleaf sheets are transported.

In addition, when mat layers obtained by electrostatic spraying are stacked and stored without a slip sheet, adhesion between plates has been known to occur particularly in a high humidity environment such as summer.

Further, in the case of a back coating layer containing an organic polymer such as a polyester resin, it was observed that when an autoloader for automatically supplying a printing material to a laser light exposing machine is used without a interleaf sheet, a scratch is easily produced on a photosensitive layer due to rubbing in the case of an autoloader having such a construction that a photosensitive layer and an organic polymer layer are pressed together.

### SUMMARY OF THE INVENTION

The present invention has been made in view of the above circumstances and provides an infrared-sensitive planographic printing plate precursor.

An aspect of the invention provides an infrared sensitive planographic printing plate precursor comprising: a support; a recording layer disposed on or above a surface of the support and capable of forming an image by infrared irradiation, the recording layer comprising a water-insoluble and alkali-soluble resin and an infrared absorbent; and an organic polymer layer disposed on or above the other surface of the support, the organic polymer layer comprising a crosslinked polymer particle having a number-average particle diameter of 1 to 100µm, and the organic polymer layer contains at least one organic polymer selected from an epoxy resin and a resol resin.

When an epoxy resin or a resol resin is used as the organic polymer, it is preferable to use a crosslinking agent in combination therewith.

In the invention, it is necessary that a surface of the support opposite to a surface having a recording layer has an organic polymer layer, and the organic polymer layer contains a crosslinked polymer particle having a number-average particle diameter of 1 to 100µm.

Since this polymer layer contains a crosslinked polymer particle, it is thought that a fine convex part is formed on the layer surface. For this reason, in the invention, it is thought that since the convex part is contacted with the surface of a recording layer when a planographic printing plate precursor is stacked, stresses corresponding to scraping scratches or abrasion scratches or the like (scratch stress) is alleviated.

In addition, it is thought that since the particle constituting this convex part is a relatively soft polymer particle, when the convex part and the recording layer are contacted, stress relaxation due to deformation of the convex part itself is added, and sufficient scratch resistance is exhibited.

According to the invention, an infrared photosensitive planographic printing plate precursor which suppresses generation of scratches on a recording layer, and can prevent adhesion between plates under high humidity even when planographic printing plate precursors are stacked without using interleaf sheets can be provided.

### DETAILED DESCRIPTION OF THE INVENTION

The present invention will be explained in detail below.

The planographic printing plate precursor of the invention (hereinafter, sometimes referred to as "a planographic printing plate precursor" in some cases) comprises a support; a recording layer disposed on or above a surface of the support and capable of forming an image by infrared irradiation, the recording layer comprising a water-insoluble and alkali-soluble resin and an infrared absorbent; and an organic polymer layer disposed on or above the other surface of the support, the organic polymer layer comprising a crosslinked polymer particle having a number-average particle diameter of 1 to 100µm, wherein the organic polymer layer contains at least one organic polymer selected from an epoxy resin and a resol resin.

Details of each element constituting the planographic printing plate precursor of the invention will be sequentially explained below.

### 1. Organic polymer layer

A planographic printing plate precursor according to the invention comprises a support, a recording layer disposed on or above one surface of the support, and an organic polymer layer disposed on or above the other surface of the support, the organic polymer layer comprising a crosslinked polymer particle (hereinafter, sometimes referred to as " a specific polymer particle" in some cases) having a number-average particle diameter of 1 to 100µm, wherein the organic polymer layer contains at least one organic polymer selected from an epoxy resin and a resol resin.

First, various components constituting the organic polymer layer will be explained sequentially.

### 1-1. Specific polymer particle

As a specific polymer particle used in the invention, any particle can be used as long as it is a particle containing an organic polymer as a primary component, the organic polymer being crosslinked, and having a number-average particle diameter of 1 to 100µm, from a viewpoint of a convex part forming property on a surface of an organic polymer layer, the specific polymer particle which does not easily dissolve in a general-use organic solvent is more preferable.

The number-average particle diameter of the specific polymer particle is preferably in a range of 2 to 70µm, and more preferably in a range of 4 to 50µm.

When the number-average particle diameter is less than 1 µm, the effect of addition of the specific polymer particle cannot be exerted, and scratches are easily generateed on a recording layer and, when the diameter is greater than 100µm, the specific polymer particle is easily detached.

In the invention, the number-average particle diameter is measured by an electron microscope method.

The organic polymer constituting a specific polymer particle in the invention is required not to be dissolved in an organic solvent which is used for dissolving a base polymer constituting the organic polymer layer. Therefore, in order that the polymer is not dissolved in a normally used organic solvent such as methyl ethyl ketone, a polymer having a crosslinked structure is preferable. A method of making a polymer having such a crosslinked structure particulate may be any method, however a method by emulsion polymerization is desirable. In addition, a narrower distribution of a particle diameter is preferable and, for this, fractionating work may be performed.

Alternatively, for forming a crosslinked structure, a method of polymerization by mixing a polyfunctional vinyl-based monomer in a monomer to be vinyl-polymerized, that is, a method of performing so-called vulcanization can be adopted.

Specific examples include a crosslinked acrylic acid ester-based polymer such as a methyl methacrylate-ethylene glycol dimethacrylate copolymer (e.g. Techpolymer; MBX-15, MBX-15S, MBX-15SS, MBX-20, and MB30X-20, all manufactured by Sekisui Plastics Co., Ltd.), an ethyl methacrylate/ethylene glycol diacrylate copolymer, an ethyl acrylate/ethylene glycol diacrylate copolymer (e.g. Techpolymer; ARX-15, ARX-806, all manufactured by Sekisui Plastics Co., Ltd.); a crosslinked polystyrene (e.g. Techpolymer; SBX-12, SBX-17, all manufactured by Sekisui Plastics Co., Ltd.); a silicone rubber-based crosslinked silicone resin (e.g. Trefil; E-500, E-600, E-601, all manufactured by Dow Coming Toray Silicone Co., Ltd.); rubbers such as a styrene/butadiene rubber.

From a viewpoint of forming property of a convex part and suppression of scratching of a recording layer, a content of these specific polymer particles is preferably in a range of 0.3 to 40 mass %, more preferably in a range of 1 to 20 mass %, particularly preferably in a range of 4 to 15 mass % based on a total mass of an organic polymer layer. When the content of the specific polymer particle is less than 0.3 mass %, the effect of addition of the specific polymer particle is not exerted, and the effect of preventing scratching on a recording layer becomes insufficient. When the content exceeds 40 mass %, not only the manufacturing cost is increased, but also the specific polymer particle is easily detached, and this becomes a cause for stain of a light exposing device, and a developing device.

### (Organic polymer)

An organic polymer layer of the invention contains an organic polymer as a base polymer.

In the invention, from a viewpoint of solvent resistance, chemical resistance and heat resistance,the organic polymer layer is formed by using at least one kind organic polymer selected from an epoxy resin and a resol resin. When an epoxy resin or a resol resin is used, it is preferable to use a crosslinking agent in combination.

Then, an epoxy resin and a crosslinking agent therefor, and a resol resin and a corsslinking agent therefor will be explained.

As the epoxy resin suitable in the organic polymer layer, a condensate of bisphenol A and epichlorohydrin having various epoxy equivalents can be used. Such the epoxy resin can be available as a sold product, and examples include Epicoat 828, Epicoat 1001, Epicoat 1003, Epicoat 1004, Epicoat 1007, Epicoat 1009, and Epicoat 1005F (all product names) manufactured by Japan Epoxy Resins Co., Ltd.

As the epoxy resin in the invention, a condensate of bisphenol F and epichlorohydrin at various epoxy equivalents can be also used suitably, and examples include Epicoat 4004P, and Epicoat 4007P (product name) manufactured by Japan Epoxy Resins Co., Ltd.

Further, preferable examples include a condensate of a mixture of bisphenol A and bisphenol F and epichlorohydrin, such as Epicoat 152 such as Epicoat 4110, and Epicoat 4210 (product name) manufactured by Japan Epoxy Resins Co., and a condensate of a phenol resin and epichlorohydrin, , Ltd., such as Epicoat 152, and Epicoat 154 (product name) manufactured by Japan Epoxy Resins Co., Ltd.

As the crosslinking agent to be used with the epoxy resin, generally, various compounds which are used in crosslinking or curing an epoxy resin are used.

Examples of the crosslinking agent include amines such as diethylenetriamine, triethylenetetramine, metaxylenediamine, isophoronediamine, and trisdimethylaminomethylphenol, imidazoles such as 1-butyl-2-methylimidazole, 1-benzylbenzyl-2-methylimidazole, and 2-heptaimidazole, acid anhydrides such as phthalic anhydride, hexahydrophthalic anhydride, and pyromellitic anhydride, and phenols such as bisphenol A.

As the resol resin suitable in the organic polymer layer, any of general-use resins obtained by condensing phenols and formalin in the presence of an alkali can be used.

As phenols used in preparing the resol resin, carbolic acid, m-cresol, p-cresol, and o-cresol are preferably used, and a mixture thereof may be also used.

The resol resin may be used by selection depending on the purpose such as a degree of condensation of phenols and formalin, a molecular weight, and a residual ratio of a remaining monomer. Alternatively, resol resins of various grades having different these physical properties are commercially available, and they can also be used in the invention.

As used herein, the resol resin includes so-called resol resin precursor before becoming a cured-type phenol resin due to three-dimensional crosslinking.

As a commercially available product of a resol resin which can be used in the invention, specifically, Sumilight resin PR-9480, PR-14170, PR-51107, PR-51904, EM-1, PR-EPN, and PR-UFC-504 (all product names) manufactured by Sumitomo Bakelite Co., Ltd. can be used.

As the crosslinking agent which is used with the resol resin, organic acids such as paratoluenesulfonic acid, xylenesulfonic acid, oxalic acid, phenylphosphonic acid, and acidic phosphoric acid phenyl ester, and inorganic acids such as phosphoric acid, nitric acid, and hydrochloric acid can be used.

Alternatively, as the crosslinking agent, hydroxide of an alkaline earth metal such as calcium hydroxide, and oxide of an alkaline earth metal such as calcium oxide can be also used.

As used herein, the crosslinking agent includes not only a substance which itself is involved in crosslinking, but also a substance which promotes a crosslinking reaction.

As the organic polymer in the invention, the following polymers may be used, being not limiting.

Novolak resins such as phenol formaldehyde resin, m-cresol formaldehyde resin, p-cresol formaldehyde resin, m-/p-mixed cresol formaldehyde resin, and phenol/cresol (any of m-, p- or m-/p-mixed may be used) mixed formaldehyde resin, and pyrogallolacetone resin.

At least one kind resin selected from the group consisting of a saturated copolymer polyester resin, a phenoxy resin, a polyvinyl acetal resin and a vinylidene chloride copolymer resin.

The saturated copolymer polyester resin consists of a dicarboxylic acid unit and a diol unit. Examples of a dicarboxylic acid unit of a polyester used in the invention include aromatic dicarboxylic acids such as phthalic acid, terephthalic acid, isophthalic acid, tetrabromophthalic acid, and tetrachlorophthalic acid; saturated aliphatic dicarboxylic acids such as adipic acid, azelaic acid, succinic acid, oxalic acid, suberic acid, sebacic acid, malonic acid, and 1,4-cyclohexanedicarboxylic acid.

Examples of the diol unit include aliphatic chain diols such as ethylene glycol, diethylene glycol, triethylene glycol, polyethylene glycol, propylene glycol, dipropylene glycol, polypropylene glycol, 1,3-dibutylene glycol, 2,3-butylene glycol, 1,4-butylene glycol, neopentyl glycol, hexanediol, and 2,2,4-trimethyl-1,3-pentanediol; cyclic diols such as 1,4-bis-β-hydroxyethoxycyclohexane, cyclohexanedimethanol, tricyclodecanedimethanol, bisphenol dioxyethyl ether, and bisphenol dioxypropyl ether.

These dicarboxylic acids and diol units are used as a copolymer unit in which each of them is one or more kinds, and one of them is two or more kinds, and a nature of a copolymer is determined by a copolymerization composition and a molecular weight.

The organic polymer layer in the invention is preferably provided effectively by a method of forming a coated film using a coating solution, and drying this as described later. Therefore, when a copolymer polyester resin is used as an organic polymer, a resin, which is non-crystalline and is easily dissolved in various industrial organic solvents, is preferable.

When a copolymer polyester resin is used as the organic polymer, a molecular weight thereof is preferably 10,000 or more from a viewpoint of film strength of the organic polymer layer.

The phenoxy resin is prepared from bisphenol A and epichlorohydrin like an epoxy resin, and is excellent in chemical resistance and adherability without assisting action of a curing agent and a catalyst as compared with an epoxy resin, and is suitable as a primary component for back coating.

The polyvinyl acetal resin is a resin obtained by acetalizing polyvinyl alcohol with aldehyde such as butylaldehyde and formaldehyde, and a polyvinyl butyral resin and a polyvinyl formal resin are preferably used. These polyvinyl acetal resins are different in a physical nature and a chemical nature depending on an acetalization degree, a composition ratio of a hydroxy group and an acetyl group, and a polymerization degree and, in an organic polymer layer in the invention, a resin having a glass transition temperature of 60°C or higher is preferable.

As the vinylidene chloride copolymer resin, a copolymer resin of a vinylidene chloride monomer with a vinyl monomer such as vinyl chloride, vinyl acetate, ethylene and vinyl methyl ether, or an acryl monomer such as (meth)acrylic acid ester and (meth)acrylonitrile is used. Among these, a vinylidene chloride copolymer containing acrylonitrile in a range of 20 mole% or less is rich in solubility in a general-use organic solvent, being preferable.

The content of the organic polymer contained of the organic polymer layer is preferably 99.7 to 40 mass %, more preferably 99 to 60 mass %, particularly preferably 98 to 80 mass %, with respect to the total solid content of the organic polymer layer.

In addition, as described above, when the epoxy resin or the resol resin is used, a content of the crosslinking agent to be used in combination in the organic polymer layer is preferably in a range of 0.3 to 30 mass %, more preferably in a range of 1 to 20 mass % in terms of a solid content.

The organic polymer layer may contain, in addition to the organic polymer described above, another polymer compounds as needed. Preferable examples of the hydrophobic polymer compounds include polybutene, polybutadiene, polyamide, unsaturated copolymeric polyester resins, polyurethane, polyurea, polyimide, polysiloxane, polycarbonate, epoxy resins, chlorinated polyethylene, alkylphenol aldehyde condensation resins, polyvinyl chloride, polyvinylidene chloride, polystyrene, acrylic resins and the copolymers thereof, hydroxycellulose, polyvinylalcohol, cellulose acetate, carboxymethylcellulose, and the like.

Examples of other preferable hydrophobic polymer compound include copolymers usually having a molecular weight of 10,000 to 200,000, which contains monomers shown in the following (1m) to (12m) as its structural unit.

(1m) Acrylamides, methacrylamides, acrylic acid esters, methacrylic acid esters and hydroxystyrenes, which have an aromatic hydroxy group, such as N-(4-hydroxyphenyl)acrylamide or N-(4-hydroxyphenyl)methacrylamide, o-, m- or p-hydroxystyrene, o-, m- or p-hydroxyphenyl acrylate or methacrylate.

(2m) Acrylic acid esters and methacrylic acid esters, which have an aliphatic hydroxy group, such as 2-hydroxyethyl acrylate or 2-hydroxyethyl methacrylate.

(3m) (Substituted) acrylic acid esters such as methyl acrylate, ethyl acrylate, propyl acrylate, butyl acrylate, amyl acrylate, hexyl acrylate, cyclohexyl acrylate, octyl acrylate, phenyl acrylate, benzyl acrylate, 2-chloroethyl acrylate, 4-hydroxybutyl acrylate, glycidyl acrylate, and N-dimethylaminoethyl acrylate.

(4m) (Substituted) methacrylic acid esters such as methyl methacrylate, ethyl methacrylate, propyl methacrylate, butyl methacrylate, amyl methacrylate, hexyl methacrylate, cyclohexyl methacrylate, octyl methacrylate, phenyl methacrylate, benzyl methacrylate, 2-chloroethyl methacrylate, 4-hydroxybutyl methacrylate, glycidyl methacrylate, and N-dimethylaminoethyl methacrylate.

(5m) Acrylamides or methacrylamides such as acrylamide, methacrylamide, N-methylolacrylamide, N-methylolmethacrylamide, N-ethylacrylamide, N-ethylmethacrylamide, N-hexylacrylamide, N-hexylmethacrylamide, N-cyclohexylacrylamide, N-cyclohexylmethacrylamide, N-hydroxyethylacrylamide, N-hydroxyethylacrylamide, N-phenylacrylamide, N-phenylmethacrylamide, N-benzylacrylamide, N-benzylmethacrylamide, N-nitrophenylacrylamide, N-nitrophenylmethacrylamide, N-ethyl-N-phenylacrylamide and N-ethyl-N-phenylmethacrylamide.

(6m) Vinyl ethers such as ethyl vinyl ether, 2-chloroethyl vinyl ether, hydroxyethyl vinyl ether, propyl vinyl ether, butyl vinyl ether, octyl vinyl ether, and phenyl vinyl ether.

(7m) Vinyl esters such as vinyl acetate, vinyl chloroacetate, vinyl butyrate, and vinyl benzoate.

(8m) Styrenes such as styrene, methylstyrene, and chloromethylstyrene.

(9m) Vinyl ketones such as methyl vinyl ketone, ethyl vinyl ketone, propyl vinyl ketone, and phenyl vinyl ketone.

(10m) Olefins such as ethylene, propylene, isobutylene, butadiene, and isoprene.

(11m) N-vinylpyrrolidone, N-vinylcarbazole, 4-vinylpyridine, acrylonitrile, methacrylonitrile etc.

(12m) Acrylamides such as N-(o-aminosulfonylphenyl)acrylamide, N-(m-aminosulfonylphenyl)acrylamide, N-(p-aminosulfonylphenyl)acrylamide, N-[1-(3-aminosulfonyl)naphthyl]acrylamide, and N-(2-aminosulfonylethyl)acrylamide, methacrylamides such as N-(o-aminosulfonylphenyl)methacrylamide, N-(m-aminosulfonylphenyl)methacrylamide, N-(p-aminosulfonylphenyl)methacrylamide, N-[1-(3-aminosulfonyl)naphthyl]methacrylamide, and N-(2-aminosulfonylethyl)methacrylamide, unsaturated sulfonamides of acrylic acid esters such as o-aminosulfonylphenyl acrylate, m-aminosulfonylphenyl acrylate, p-aminosulfonylphenyl acrylate, and 1-(3-aminosulfonylphenylnaphthyl)acrylate, and unsaturated sulfonamides of methacrylic acid esters such as o-aminosulfonylphenyl methacrylate, p-aminosulfonylphenyl methacrylate, and 1-(3-aminosulfonylphenylnaphthyl) methacrylate.

In addition, the monomer described above may be copolymerized with another copolymerizable monomer. The preferable hydrophobic polymer compounds also include, but are not limited to, the copolymers obtained by copolymerization of the monomers described above and additional modification, for example, with glycidyl acrylate, glycidyl methacrylate, or the like.

These hydrophobic polymer compounds can be added in an amount of 50 mass % or less relative to the total solid contents in the organic polymer layer, however, they are preferably added in an amount of 30 mass % or less for the purpose of utilizing the characteristics of saturated copolyester resin, phenoxy resin, polyvinylacetal resin, and vinylidene chloride copolymer resin which are used preferably as the organic polymer.

### 1-2. Other components

### (Filler)

When the epoxy resin or the resol resin is used as the organic polymer in the invention, various fillers can be added. Examples of the fillers include a calcium carbonate powder, a silica powder, a wooden powder, and a pulp.

The content of the fillers is preferably in a range of 1 to 50 mass %, more preferably 5 to 30 mass % with respect to the solid contents in the organic polymer layer.

### (Additive)

The organic polymer layer may contain a plasticizer, a surfactant, and other additives for the purposes of imparting flexibility, controlling slipping property, improving coating surface, and the like, if necessary, as long as the effect of the invention is not thereby impaired.

### -Plasticizer-

Preferable examples of the plasticizer include phthalic acid esters such as dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate, and diallyl phthalate, glycol esters such as dimethyl glycol phthalate, ethyl phthalylethyl glycolate, methylphthalylmethyl glycolate, butylphthalylbutyl glycolate, and triethylene glycol dicapric acid ester, phosphoric acid esters such as tricresyl phosphate, and triphenyl phosphate, aliphatic dibasic acid esters such as diisobutyl adipate, dioctyl adipate, dimethyl sebacate, dibutyl sebacate, dioctyl azelate, and dibutyl maleate, polyglycidyl methacrylate, triethyl citrate, glycerin triacetyl ester, and butyl laurate, and the like.

The amount of the plasticizer added to the organic polymer layer varies according to the kind of the organic polymer used for the organic polymer layer, and is preferably added in an amount in the range that does not decrease the glass transition temperature of the polymer layer to 60°C or lower.

### -Surfactant-

Examples of a surfactant include anionic, cationic, nonionic and amphoteric surfactants. Specific examples of the surfactant include nonionic surfactants such as polyoxyethylene alkyl ethers, polyoxyethylene alkyl phenyl ethers, polyoxy ethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerine fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamine, triethanolamine fatty acid ester, and trialkylamine oxide; anionic surfactants such as fatty acid salts, abietic acid salts, hydroxyalkanesulfonic acid salts, alkanesulfonic acid salts, dialkylsulfosuccinic acid ester salts, straight alkylbenzenesulfonate salts, branched alkylbenzenesulfonate salts, alkylnaphthalenesulfonate salts, alkylphenoxypolyoxyethylene propylsulfonate salts, polyoxyethylene alkylsulfophenylether salts, N-methyl-N-oleyltauline sodium salt, N-alkylsulfosuccinic acid monoamide disodium salt, petroleum sulfonic acid salts, sulfated tallow oil, fatty acid alkyl ester sulfate ester salts, alkylsulfate ester salts, polyoxyethylene alkyl ether sulfate ester salts, fatty acid monoglyceride sulfate ester salts, polyoxyethylene alkyl phenyl ether sulfate ester salts, polyoxy ethylene styryl phenyl ether sulfate ester salts, alkyl phosphate ester salts, polyoxyethylene alkyl ether phosphate ester salts, polyoxyethylene alkyl phenyl ether phosphate ester salts, partially saponified styrene/maleic anhydride copolymer, partially saponified olefin/maleic anhydride copolymer, and naphthalenesulfonate salt formalin condensate; cationic surfactants such as alkylamine salts, quaternary ammonium salts, polyoxyethylene alkylamine salts, and polyethylenepolyamine derivative; and amphoteric surfactants such as carboxybetaines, aminocarboxylic acids, sulfobetaines, aminosulfate esters, and imidazolines. Among the above surfactants, polyoxyethylene can be read as polyoxyalkylene such as polyoxymethylene, polyoxypropylene, and polyoxybutylrene, and those surfactants are also included.

Still more preferable surfactants are fluorochemical surfactants containing a perfluoroalkyl group in the molecule. Examples of the fluorochemical surfactants include anionic surfactants such as perfluoroalkylcarboxylate salts, perfluoroalkylsulfonate salts, and perfluoroalkylphosphate esters; ampholytic surfactants such as perfluoroalkylbetaines; cationic surfactants such as perfluoroalkyltrimethylammonium salt; and nonionic surfactants such as perfluoroalkylamine oxides, perfluoroalkylethyleneoxide adducts, oligomers containing perfluoroalkyl and hydrophilic groups, oligomers containing perfluoroalkyl and oleophilic groups, oligomers containing perfluoroalkyl, hydrophilic and oleophilic groups, and urethanes containing perfluoroalkyl and oleophilic groups; and the like.

The surfactants may be used alone or in combination of two or more, in an amount of preferably in the range of 0.001 to 10 mass %, more preferably 0.01 to 5 mass % in the organic polymer layer.

### -Other additive-

The organic polymer layer may contain additionally other additives including a dye for coloring, a silane-coupling agent for improvement in adhesion to aluminum supporting plate, a diazonium salt-containing diazo resin, an organic phosphonic acid, an organic phosphoric acid, a cationic polymer, and a lubricant such as common wax, higher fatty acid, higher fatty acid amide, dimethylsiloxane-based silicone compound, modified dimethylsiloxane, or polyethylene powder.

The thickness of the organic polymer layer is arbitrary, if it is a thickness resistant to scratching on the recording layer without use of interleaf sheet, and is preferably in the range of 0.05 to 50 µm, more preferably 0.5 to 25 µm, and still more preferably 1.0 to 20 µm. When the thickness is in the range above, it is possible to prevent scratching or the like on the recording layer effectively, even when the planographic printing plate precursors are handled as stacked.

### 1-3. Formation of organic polymer layer

The organic polymer layer in the invention can be formed by dissolving respective components constituting the organic polymer layer in a solvent, and dispersing a specified polymer particle to prepare a coating solution, applying the coating solution onto a surface (back side) opposite to a surface on which a recording layer on a support is formed and, thereafter, heating and drying the applied coating solution.

As the solvent to be used, organic solvents such as those described in JP-A No. 62-251739 can be used alone, or by mixing them. Examples of the solvent are not limited to, but include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, and toluene. These solvents are used alone, or by mixing them.

### 1-4. Properties of organic polymer layer

The organic polymer layer has a property in that a dynamic friction coefficient on a surface of the organic polymer layer is in a range of 0.38 to 1.2 from the viewpoint in that the effect of the invention is exerted sufficiently. Upon formation of the organic polymer layer, in view of such the point, a kind and an addition amount of the specific polymer particle and the organic polymer may be determined.

The expression " dynamic friction coefficient " means a value measured by placing a surface of the organic polymer layer so as to contact with a surface of the recording layer that is opposite to the organic polymer layer according to the standard ASTM D1894, the disclosure of which is incorporated by reference herein.

As a result, even when the infrared sensitive planographic printing plate precursors according to the invention are stacked without interleaf sheets, it is possible to obtain the advantageous effects of eliminating the scratching defects of the recording layer in the production, processing and platemaking processes or during conveyance for packaging and transportation as product.

Thus, for example, there is no scratching defect generated on the recording layer due to the friction between the recording layer and the organic polymer layer in contact with each other by vibration during transportation, even when the planographic printing plate precursors are packaged and transported as they are stacked. It is also possible to prevent generation of scratches on the recording layer, even if a region of the recording and backcoat layers of the plate material is pressed tightly to each other, for example, when the infrared-sensitive planographic printing plate precursors according to the invention are supplied into an exposure device equipped with an auto-loader.

### 2. Recording layer

The recording layer in the invention is a layer which contains a water-insoluble and alkali-soluble resin and an infrared absorbent, and can form an image by infrared irradiation, and may be any of a monolayer structure and a multilayer structure.

When the recording layer has a monolayer structure, it contains a water-insoluble and alkali-soluble resin and an infrared absorbent.

Alternatively, when the recording layer has a multilayer structure, it contains a water-insoluble and alkali-soluble resin, and at least one of the layer further contains an infrared absorbent.

### 2-1. Water-insoluble and alkali-soluble resin

A water-insoluble and alkali-soluble resin used in the recording layer of the invention (hereinafter, sometimes referred to as "alkali-soluble resin") includes a homopolymer containing an acidic group on the main or side chain of the polymer or the copolymer or mixture thereof. Accordingly, the recording layer according to the invention has a property that it is easily dissolved in an alkaline developing solution upon contact. The alkali-soluble resin for use in the invention is not particularly limited if it is a known resin, and is preferably a polymer compound having at least one acidic group selected from (1) phenolic hydroxyl groups, (2) sulfonamide groups, (3) active imide groups, and (4) a carboxylic acid group in the molecule.

Examples of the alkali-soluble resin include, but are not limited to, the following resins.

Examples of the polymer compounds containing a phenolic hydroxyl group (1) include novolak resins such as phenol formaldehyde resins, m-cresol formaldehyde resins, p-cresol formaldehyde resins, mixed m-/p-cresol formaldehyde resins, and mixed phenol/cresol (m-, p-, or mixed m-/p-) formaldehyde resins; and pyrogallol acetone resins.

Preferable examples of the alkali-soluble resin containing a phenolic hydroxyl group include resins prepared by condensation of a substituted phenol represented by the following formula (i) and an aldehyde.

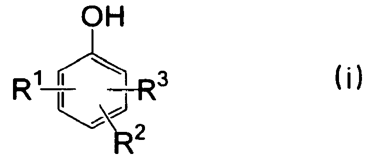

In formula (i), R¹ and R² each independently represent a hydrogen atom, an alkyl group, or a halogen atom. An alkyl group is preferably an alkyl group having 1 to 3 carbon atoms, more preferably an alkyl group having 1 or 2 carbon atoms. A halogen atom is any of a fluorine atom, a chlorine atom, a bromine atom and an iodine atom, preferably a chlorine atom or a bromine atom. R³ represents an alkyl group or a cycloalkyl group having 3 to 6 carbon atoms.

Examples of the substituted phenols include isopropylphenol, t-butylphenol, t-aminophenol, hexylphenol, cyclohexylphenol, 3-methyl-4-chloro-6-tertiary butyl phenol, isopropylbutyl cresol, t-butylcresol, and t-amylcresol. Among them, t-butylphenol, and t-butylcresol are preferable.

Examples of the aldehydes used in condensation with the substituted phenols described above include aliphatic and aromatic aldehydes such as formaldehyde, acetoaldehyde, acrolein, and crotonaldehyde. Among them, formaldehyde and acetoaldehyde are preferable.

Other examples of the alkali-soluble resin containing a phenolic hydroxyl group include polymer compounds having a phenolic hydroxyl group on the side chain. Examples of the polymer compounds having a phenolic hydroxyl group on the side chain include homopolymers of a low-molecular weight compound having one or more phenolic hydroxyl groups and one or more polymerizable unsaturated bonds, and copolymers thereof with another polymerizable monomer.

Examples of the polymerizable monomer having a phenolic hydroxy group include acrylamide, methacrylamide, acrylic acid ester, methacrylic acid ester, and hydroxystyrene, which have a phenolic hydroxy group. Specific examples of the polymerizable monomer include N-(2-hydroxyphenyl)acrylamide, N-(3-hydroxyphenyl)acrylamide, N-(4-hydroxyphenyl)acrylamide, N-(2-hydroxyphenyl)methacrylamide, N-(3-hydroxyphenyl)methacrylamide, N-(4-hydroxyphenyl)methacrylamide, o-hydroxyphenyl acrylate, m-hydroxyphenyl acrylate, p-hydroxyphenyl acrylate, o-hydroxyphenyl methacrylate, m-hydroxyphenyl methacrylate, p-hydroxyphenyl methacrylate, o-hydroxystyrene, m-hydroxystyrene, p-hydroxystyrene, 2-(2-hydroxyphenyl)ethyl acrylate, 2-(3-hydroxyphenyl)ethyl acrylate, 2-(4-hydroxyphenyl)ethyl acrylate, 2-(2-hydroxyphenyl)ethyl methacrylate, 2-(3-hydroxyphenyl)ethyl methacrylate, and 2-(4-hydroxyphenyl)ethyl methacrylate, and the like. The alkali-soluble resins having a phenolic hydroxyl group may be used in combination of two or more.

Examples of the alkali-soluble resin having a phenolic hydroxyl group for use in the invention include the alkali-soluble resin having a phenolic hydroxyl group at least part of the phenolic hydroxyl groups therein are esterified described in JP-A No. 11-288089.

Examples of the alkali-soluble resin having a sulfonamide group (2) include homopolymers of a sulfonamide group-containing polymerizable monomer and copolymers thereof with another polymerizable monomer. Examples of the sulfonamide group-containing polymerizable monomers include low-molecular weight polymerizable compounds having one or more sulfonamide groups -NH-SO₂- of which the nitrogen is bound to at least one hydrogen atom and one or more polymerizable unsaturated bonds in the molecule. Among them, low-molecular weight compounds having an acryloyl, allyl, or vinyloxy group and a substituted or monosubstituted aminosulfonyl group or a substituted sulfonylimino group are preferable.

Specific examples of the alkali-soluble resin having a sulfonamide group include those described in JP-B No. 7-69605.

The alkali-soluble resin having an active imide group (3) is preferably a resin having the active imide group (-CO-NH-SO₂-) in the molecule, and examples of the polymer compounds include homopolymers of a low-molecular weight polymerizable monomer having one or more active imide groups and one or more polymerizable unsaturated bonds in the molecule and copolymers thereof with another polymerizable monomer compound.

Specific examples of the compounds include N-(p-toluenesulfonyl)methacrylamide, N-(p-toluenesulfonyl)acrylamide, and the like.

Examples of the alkali-soluble resins having carboxylic acid group (4) include homopolymers of a low-molecular weight polymerizable monomer having one or more carboxylic acid groups and one or more polymerizable unsaturated bonds in the molecule and copolymers thereof with another polymerizable monomer. Typical examples of the carboxylic acid group-containing polymerizable monomers include α,β-unsaturated carboxylic acids such as acrylic acid, methacrylic acid, maleic acid, maleic anhydride, and itaconic acid. Other favorable examples thereof include unsaturated carboxylic acids of a monoester of the hydroxyl group in an acrylate or methacrylate having a hydroxyl group on the side chain (for example, 2-hydroxyethylethyl acrylate or methacrylate, etc.) with a dibasic acid (such as succinic acid, glutaric acid, phthalic acid, or the like).

Examples of the alkali-soluble resins according to the invention further include copolymers of two or more of the phenolic hydroxyl group-containing polymerizable monomer, the sulfonamide group-containing polymerizable monomer, the active imide group-containing polymerizable monomer, and carboxylic acid group-containing polymerizable monomer; and copolymers of two or more of the polymerizable monomers and another polymerizable monomer.

In the invention, when the alkali-soluble resin is a copolymer of monomers containing an acidic group (phenolic hydroxyl group, sulfonamide group, active imide group, or carboxylic acid group) and an other polymerizable monomer, the content of the alkali-solubilizing monomers is preferably 10 mol % or more, more preferably 20 mol % or more, from the viewpoint of alkali solubility.

Examples of the monomer components copolymerized with the acidic group-containing monomers include, but are not limited to, the following compounds (m1) to (m11):
(m1) aliphatic hydroxyl group-containing acrylic and methacrylic esters such as 2-hydroxyethyl acrylate and 2-hydroxyethyl methacrylate;
(m2) alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, and glycidyl acrylate;
(m3) alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, and glycidyl methacrylate;
(m4) acrylamides and methacrylamides such as acrylamide, methacrylamide, N-methylol acrylamide, N-ethylacrylamide, N-hexylmethacrylamide, N-cyclohexylacrylamide, N-hydroxyethylacrylamide, N-phenylacrylamide, N-nitrophenylacrylamide, and N-ethyl-N-phenylacrylamide;
(m5) vinyl ethers such as ethyl vinylether, 2-chloroethyl vinylether, hydroxyethyl vinylether, propyl vinylether, butyl vinylether, octyl vinylether, and phenyl vinylether;
(m6) vinyl esters such as vinyl acetate, vinyl chloroacetate, vinyl butyrate, and vinylbenzoate;
(m7) styrenes such as styrene, α-methylstyrene, methylstyrene, and chloromethylstyrene;
(m8) vinyl ketones such as methyl vinylketone, ethyl vinylketone, propyl vinylketone, and phenyl vinylketone;
(m9) olefins such as ethylene, propylene, isobutylene, butadiene, and isoprene;
(m10) N-vinylpyrrolidone, acrylonitrile, methacrylonitrile, and the like; and
(m11) unsaturated imides such as maleimide, N-acryloylacrylamide, N-acetylmethacrylamide, N-propionylmethacrylamide, and N-(p-chlorobenzoyl)methacrylamide.

Any one of known methods such as graft copolymerization, block copolymerization, and random copolymerization may be used for copolymerization of the alkaline water-soluble polymer compounds.

In the invention, the alkali-soluble resin preferably has a weight-average molecular weight of 2,000 or more, more preferably a weight-average molecular weight of 5,000 to 300,000, when it is a homopolymer or copolymer of the acidic group-containing polymerizable monomers. In the invention, the alkali-soluble resin preferably has a weight-average molecular weight 500 to 50,000, more preferably 700 to 20,000, and particularly preferably 1,000 to 10,000, when it is a phenol formaldehyde resin, a cresol aldehyde resin, or the like.

When the recording layer has a multilayer structure, the alkali-soluble resin used in the upper layer (the layer situated remote from a support) of recording layer is preferably a phenolic hydroxyl group-containing resin because it generates stronger hydrogen-bonding in the unexposed region and allows cleavage of part of the hydrogen bonds in the exposed region. It is more preferably a novolak resin.

Two or more alkali-soluble resins different in solubilization speed in aqueous alkaline solution may be used as mixed, and the blending ratio thereof is arbitrary. The alkali-soluble resin favorably used in the .upper layer of a multi-layered recording layer as it is mixed with a phenolic hydroxyl group-containing resin is preferably an acrylic resin, more preferably an acrylic resin having a sulfonamide or carboxylic acid group, because it has low compatibility with the phenolic hydroxyl group-containing resin.

When the recording layer has a multilayer structure, the alkali-soluble resin above is used in the lower layer (the layer situated on support side) of recording layer, which should be highly alkali-soluble particularly in nonimage region. The layer also should be resistant to the various printing chemicals used during printing and show stabilized printing durability under various printing conditions. Therefore, a resin that does not impair such properties is preferably selected. A resin superior in solubility in various alkaline developing solutions, resistance to various printing chemicals, and physical strength is preferably selected from the viewpoint above. In addition, the alkali-soluble resin used in the lower layer is preferably a resin having a smaller solvent solubility in the coating solvent for the .upper layer that is resistant to solubilization in the solvent when the .upper layer is coated. It is possible to prevent undesirable solubilization at the interface of two layers by properly selecting such a resin.

Among the alkali-soluble resins above, the alkali-soluble resin contained in the lower layer is preferably an acrylic resin from these viewpoints. In particular, an acrylic resin having a sulfonamide group is preferable.

Examples of the alkali-soluble resins used in the lower layer preferable from the viewpoint above include, in addition to the resins above, water-insoluble and alkali-soluble polyamide resins, epoxy resins, polyvinylacetal resins, styrene resins, urethane resins, and the like. Among them, urethane and polyvinylacetal resins are preferable.

The alkali-soluble resins for use in the lower layer may be used alone or in combination of two or more.

When the recording layer has a monolayer structure, the content of the alkali-soluble resin is preferably 30 to 99 mass %, more preferably 40 to 95 mass %, with respect to the total solid content of the recording layer, from the viewpoints of the sensitivity and durability of recording layer.

When the recording layer has a multilayer structure, the content of the alkali-soluble resin is preferably 40 to 98 mass %, more preferably 60 to 97 mass %, with respect to the total solid content of the upper layer , from the viewpoints of the sensitivity and durability of recording layer. The content of the alkali-soluble resin in the lower layer is preferably 40 to 95 mass %, more preferably 50 to 90 mass % with respect to the total solid content of the lower layer.

### 2-2. Development inhibitor

The recording layer may contain a development inhibitor for improvement in its inhibition (solubilization-suppressing potential). When the recording layer has a multilayer structure, the development inhibitor is preferably contained in the upper layer.

The development inhibitor is not particularly limited, if it has interaction with the alkali-soluble resin, substantially reduces the solubility of the alkali-soluble resin in the developing solution in the unexposed region, and has a weaker interaction and thus become soluble in the developing solution in the exposed region; and quaternary ammonium salts, polyethylene glycol compounds, and others are used favorably. There are some in the photo-thermal converting agents and image-coloring agents described below that function as a development inhibitor, and these compounds may also be used preferably.

Examples of the quaternary ammonium salt are not particularly limited, and examples thereof include a tetraalkylammonium salt, a trialkylarylammonium salt, a dialkyldiarylammonium salt, an alkyltriarylammonium salt, a tetraarylammonium salt, a cyclic ammonium salt, and a dicyclic ammonium salt.

Specific examples of the quaternary ammonium salt include tetrabutylammonium bromide, tetrapentylammonium bromide, tetrahexylammonium bromide, tetraoctylammonium bromide, tetralaurylammonium bromide, tetraphenylammonium bromide, tetranaphthylammonium bromide, tetrabutylammonium chloride, tetrabutylamminoum iodide, tetrastearylammonium bromide, lauryltrimethylammonium bromide, stearyltrimethylammmonium bromide, behenyltrimethylammonium bromide, lauryltriethylammonium bromide, phenyltrimethylammonium bromide, 3-trifluoromethylphenyltrimethylammonium bromide, benzyltrimethylammonium bromide, dibenzyldimethylammonium bromide, distearyldimethylammonium bromide, tristearylmethylammonium bromide, benzyltriethylammonium bromide, hydroxyphenyltrimethylammonium bromide, and N-methylpyridinium bromide. Particularly, quaternary ammonium salts described in JP-A Nos. 2003-167332 and 2003-107688 are preferable.

From a viewpoint of the development inhibiting effect and film forming property of the alkali-soluble resin, an addition amount of a quaternary ammonium salt, in the case of a monolayer-type recording layer, is preferably 0.1 to 50 mass %, more preferably 1 to 30mass % based on a total solid content of a recording layer. In the case of a multilayer-type recording layer, the amount is preferably 0.1 to 50mass %, more preferably 1 to 30 mass % based on a total solid content of an upper layer.

From the viewpoints of development inhibition efficiency and easiness in coating the alkali-soluble resin, the amount of the quaternary ammonium salt added is preferably 0.1 to 50 mass %, more preferably 1 to 30 mass %, with respect to the total solid content of the recording layer having a monolayer single-layered recording layer is used. Alternatively when a multi-layered recording layer is used, it is preferably 0.1 to 50 mass %, more preferably 1 to 30 %, mass with respect to the total solid matters in the upper layer.

The polyethylene glycol compound is not particularly limited, and examples thereof include compounds having a structure represented by the following formula (1).

R⁶¹ - (- O - (R⁶³ - O -)ₘ - R⁶²)ₙ (1)

In formula (1), R⁶¹ represents a polyvalent alcohol residue or a polyvalent phenol residue; and R⁶² represents a hydrogen atom or an alkyl, alkenyl, alkynyl, alkyloyl, aryl or aryloyl group having 1 to 25 carbon atoms that may be substituted. R⁶³ represents an alkylene residue that may be substituted; m is an integer of 10 or more on average; and n is an integer of 1 or more and 4 or less.

Examples of the polyethylene glycol compound represented by formula (1) include polyethylene glycols, polypropylene glycols, polyethylene glycol alkyl ethers, polypropylene glycol alkyl ethers, polyethylene glycol aryl ethers, polypropylene glycol aryl ethers, polyethylene glycol alkyl aryl ethers, polypropylene glycol alkyl aryl ethers, polyethylene glycol glycerin esters, polypropylene glycol glycerin esters, polyethylene sorbitol esters, polypropylene glycol sorbitol esters, polyethylene glycol fatty acid esters, polypropylene glycol fatty acid esters, polyethylene glycolated ethylenediamines, polypropylene glycolated ethylenediamines, polyethylene glycolted diethylenetriamines, and polypropylene glycolated diethylenetriamines.

Further, specific examples of them include polyethylene glycol 1000, polyethylene glycol 2000, polyethylene glycol 4000, polyethylene glycol 10000, polyethylene glycol 20000, polyethylene glycol 5000, polyethylene glycol 100000, polyethylene glycol 200000, polyethylene glycol 500000, polypropylene glycol 1500, polypropylene glycol 3000, polypropylene glycol 4000, polyethylene glycol methyl ether, polyethylene glycol ethyl ether, polyethylene glycol phenyl ether, polyethylene glycol dimethyl ether, polyethylene glycol diethyl ether, polyethylene glycol diphenyl ether, polyethylene glycol lauryl ether, polyethylene glycol dilauryl ether, polyethylene glycol nonyl ether, polyethylene setyl ethyl ether, polyethylene glycol stearyl ether, polyethylene glycol distearyl ether, polyethylene glycol behenyl ether, polyethylene glycol dibehenyl ether, polypropylene glycol methyl ether, polypropylene glycol ethyl ether, polypropylene glycol phenyl ether, polypropylene glycol dimethyl ether, polypropylene glycol diethyl ether, polypropylene glycol diphenyl ether, polypropylene glycol lauryl ether, polypropylene glycol dilauryl ether, polypropylene glycol nonyl ether, polyethylene glycol acetyl ester, polyethylene glycol diacetyl ester, polyethylene glycol benzoic acid ester, polyethylene glycol lauryl ester, polyethylene glycol dilauryl ester, polyethylene glycol nonylic acid ester, polyethylene glycol cetylic acid ester, polyethylene glycol stearoyl ester, polyethylene glycol distearoyl ester, polyethylene glycol behenic acid ester, polyethylene glycol dibehenic acid ester, polypropylene glycol acetyl ester, polypropylene glycol diacetyl ester, polypropylene glycol benzoic acid ester, polypropylene glycol dibenzoic acid ester, polypropylene glycol lauic ester, polypropylene glycol dilauric acid ester, polypropylene glycol nonylic acid ester, polyethylene glycol glycerin ether, polypropylene glycol glycerin ether, polyethylene glycol sorbitol ether, propylene glycol sorbitol ether, polyethylene glycolated ethylenediamine, polypropylene glycolated ethylenediamine, polyethylene glycolated diethylenetriamine, propylene glycolted diethylenetriamine, and polyethylene glycolated pentamethylenehexamine.

From a viewpoint of development inhibition and image forming property, the amount of the polyethylene glycol compound to be added is preferably 0.1 to 50 mass %, more preferably 1 to 30 mass % based on the total solid content of the recording layer, when the recording layer has a monolayer structure. When the recording layer has a multilayer structure, the amount of the polyethylene glycol compound to be added is preferably 0.1 to 50 mass %, more preferably 1 to 30 mass % based on the total solid content of the upper layer.

Although such a measure to improve the inhibition (solubilization-suppressing potential) often leads to deterioration in sensitivity, addition of the lactone compound described in JP-A No. 2002-361066 to the upper layer is effective in avoiding the deterioration in sensitivity.

From a viewpoint of improving inhibition of an image part into a developer, it is preferable to use in combination, as a dissolution inhibitor, a substance which is thermally degradable and, in the state where it is not degraded, substantially reduces solubility of an alkali-soluble resin, such as an onium salt, an o-quinonediazide compound, an aromatic sulfone compound, and an aromatic sulfonic acid ester compound, in addition to the aforementioned inhibitors.

Combined use of a thermal-decomposable substance, such as onium salt, o-quinonediazide compound, aromatic sulfone compound, or aromatic sulfonic ester compound, that substantially decreases the solubility of the alkali-soluble resin when it is not decomposed, with the compound above as solubilization inhibitor is preferable, for improvement of the inhibition of the developing solution in the image region.

Examples of the onium salt used in the invention include a diazonium salt, an ammonium salt, a phosphonium salt, an iodonium salt, a sulfonium salt, a selenonium salt, and an arsonium salt, and particularly preferable examples include diazonium salts described in S.I.Schlesinger, Photogr. Sci. Eng., 18, 387(1974), T. S. Balet al, Polymer, 21, 423 (1980), and JP-A No. 5-158230, ammonium salts described in U.S. Patent No. 4,069,055, U.S. Patent No. 4,069,056, and JP-A No. 3-140140, phosphonium salts described in D. C. Necker et al, Macromolecules, 17, 2468 (1984), C. S. Wen et al, The, Proc. Conf. Rad. Quring Asia P478 Tokyo, Oct (1988), U.S. Patent No. 4,069,055, and U.S. Patent No. 4,069,056, iodonium salts described in J. V. Crivello et al, Macromolecules, 10(6), 1307(1977), Chem. & Eng. News, Nov.28,p31(1988), EP No. 104,143,U.S. Patent No. 5,041,358, U.S. Patent No. 4,491,628, JP-A No. 2-150848, and JP-A No. 2-296514, sulfonium salts described in J.V.Crivello et al, Polymer J.17, 73(1985), J.V.Crivello et al, J.Org. Chem.43,3055 (1978), W.R.Watt et al,J.Polymer Sci.,Polymer Chem.Ed.,22,1989(1984)J.V.Crivello et al,Polymer Bull.,14,279(1985), J.V.Crivello et al,Macromolecules,14(5),1141(1981), J.V.Crivello et al,J.Polymer Sci.,Polymer Chem.Ed.,17,2877(1979), EP Nos. 370,693, 233,567, 297,443, and 297,442, U.S. Patent Nos. 4,933,377, 3,902,114, 4,491,628, 4,760,013, 4,734,444, and 2,833,827, German Patent Nos. 2,904,626, 3,604,580, and 3,604,581, selenonium salts described in J.V.Crivello et al,Macromolecules,10(6),1307(1977), J.V.Crivello et al,J.Polymer Sci.,Polymer Chem.Ed.,17,1047(1979), and arsonium salts described in C.S.Wen et al, The Proc. Conf. Rad. Curing ASIA,p478 Tokyo,Oct(1988).

Among such the onium salts, a diazonium salt is particularly preferable. Particularly preferable examples of a diazonium salt include diazonium salts described in JP-A No. 5-158230.

Examples of a counter ion of the onium salt include anions from tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid, and paratoluenesulfonic acid. Among them, anions from hexafluorophosphoric acid, and aromatic sulfonic acid such as triisopropylnaphathalenesulfonic acid and 2,5-dimethylbenzenesulfonic acid are preferable.

Examples of preferable quinonediazides include an o-quinonediazide compound. An o-quinonediazide compound used in the invention is a compound having at least one o-quinonediazido group, and increases alkali solubility by thermal degradation, and compounds having a variety of structures can be used. That is, o-quinonediazide assists solubility of an upper layer due to both effects of loss of inhibition as a development inhibitor due to thermal degradation, and change of o-quinonediazide itself into an alkali-soluble substance.

As such the o-quinonediazide compound, for example, compounds described in J.Coser "Light-Sensitive-Systems" (John Wiley & Sons. Inc.), pp339-352 can be used and, particularly, sulfonic acid ester or sulfonic acid amide of o-quinonediazide obtained by reacting with various aromatic polyhydroxy compounds or aromatic amino compounds are preferable. In addition, an ester of benzoquinone-(1,2)-diazidosulfonic acid chloride or naphthoquinone-(1,2)-diazido-5-sulfonic acid chloride and pyrogallol-acetone resin described in JP-B No. 43-28403, and an ester of benzoquinone-(1,2)-diadizosulfonic acid chloride or naphthoquinone-(1,2)-diazido-5-sulfonic acid chloride and phenol-formaldehyde resin described in U.S. Patent Nos. 3,046,120 and 3,188,210 are also preferably used.

Further, an ester of naphthoquinone-(1,2)-diazido-4-sulfonic acid chloride and phenol formaldehyde resin or cresol-formaldehyde resin, and an ester of naphthoquinone-(1,2)-diazido-4-sulfonic acid chloride and pyrogallol-acetone resin are also preferably used. Other useful o-quinonediazide compounds are reported and known in many patents. Examples include those described in JP-A No. 47-5303, JP-A No. 48-63802, JP-A No. 48-63803, JP-ANo. 48-96575, JP-ANo. 49-38701, JP-ANo. 48-13354, JP-B No. 41-11222, JP-B No. 45-9610, JP-B No. 49-17481, U.S. Patent Nos. 2,797,213, 3,454,400, 3,544,323, 3,4,573,913, 3,674,695, and 3,785,825, British Patent Nos. 1,227,602, 1,251,345, 1,267,005, 1,329,888, and 1,330,932, and German Patent No. 854,890.

The amount of the o-quinonediazide compound to be added is preferably in a range of 1 to 50 mass %, more preferably 5 to 30 mass % based on the total solid content of the recording layer, when the recording layer has a monolayer structure. The amount of the o-quinonediazide compound is preferably in a range of 1 to 50 mass %, further preferably 5 to 30 mass %, particularly preferably 10 to 30 mass % based on the total solid content of the upper layer, when the recording layer has a multilayer structure. These compounds may be used alone, or may be used as a mixture of a few kinds.

The polymers of the (meth)acrylate monomer having two or more perfluoroalkyl groups and having 3 to 20 carbon atoms in the molecule described in JP-A No. 2000-187318 are preferably used additionally, for the purpose of strengthening the inhibition of recording layer surface and improving the surface resistance to scratching.

When the recording layer has a monolayer structure, the addition amount of the polymer is preferably 0.1 to 10 mass %, more preferably 0.5 to 5 mass %, with respect to the total solid content of the recording layer. When the recording layer has a multilayer structure, the addition amount of the polymer is preferably 0.1 to 10 mass %, more preferably 0.5 to 5 mass %, with respect to the total solid content of the upper layer.

### 2-3. Infrared absorbent

The recording layer in the invention contains an infrared absorbent.

Addition of an infrared absorbent having the absorption maximum in the infrared region and a photo-thermal converting potential makes it possible to record an image on the planographic printing plate precursor of the invention by irradiation of infrared laser.

The infrared absorbent for use in the invention is not particularly limited, if it is a dye absorbing infrared or near-infrared light and generating heat, and any one of known infrared absorbents may be used.

When the recording layer of the invention has a multilayer structure, at least one of the layer closest to the support (lower layer) and the layer farthest from the support (upper layer) is a layer containing the infrared absorbent, and it is preferable to add an infrared absorbent both to the lower and upper layers.

As the infrared absorbent, commercially available dyes and the known dyes described in the references (e.g. "Dye Handbook", edited by Society of Organic Synthesis Chemistry, Published in 1970) can be utilized. Specifically, examples include dyes such as azo dyes, metal complex salt azo dyes, pyrazoloneazo dyes, anthraquinone dyes, phthalocyanine dyes, carbonium dyes, quinoneimine dyes, methine dyes, and cyanine dyes. In the invention, among these dyes, dyes absorbing infrared light or near infrared light are particularly preferable in that they are suitable in use for lasers emitting infrared light or near infrared light.

Examples of preferable dye include cyanine dyes described in JP-ANo. 58-125246, JP-A No. 59-84356, JP-A No. 60-78787, and U.S. Patent No. 4,973,572, methine dyes described in JP-A No. 58-173696, JP-A No. 58-181690, and JP-A No. 58-194595, naphthoquinone dyes described in JP-A No. 58-112793, JP-A No. 58-224793, JP-A No. 59-48187, JP-A No. 59-73996, JP-A No. 60-52940, and JP-A No. 60-63744, squarylium dyes described in JP A No. 58-112792, and cyanine dyes described in British Patent No. 434,875.

In addition, as a dye, a near infrared absorbing sensitizers described in U.S. Patent No. 5,156,938 are also preferably used, and arylbenzo(thio)pyrylium salts described in U.S. Patent No. 3,881,924, trimethinethiapyrylium salts described in JP-A No. 57-142645 (U.S. Patent No. 4,327,169), pyrylium-based compounds described in JP-A Nos. 58,181051, 58-220143, 59-41363, 59-84248, 59-84249, 59-146063, and 59-146061, cyanine dyes described in JP-A No. 59-216146, pentamethinethiopyrylium salts described in U.S. Patent No. 4,283,475, and pyrylium compounds described in JP-B Nos. 5-13514, and 5-19702 and, as a commercially availably product, Epolight III-178, Epolight III-130, and Epolight III-125 manufactured by Epolin are particularly preferably used.

In addition, particularly preferable other examples of a dye include near infrared absorbing dyes described as the formulas (I) and (II) in U.S. Patent No. 4,756,993.

Among these dyes, particularly preferable examples include cyanine dyes, squarylium dyes, pyrylium salts, nickel thiolate complexes, and indoleninecyanine dyes. Cyanine dyes and indoleninecyanine dyes are further preferable, and one particularly preferable example includes a cyanine dye represented by the following formula (a):

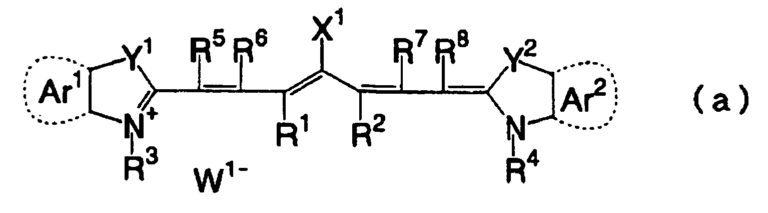

In formula (a), X' represents a hydrogen or halogen atom, -NPh₂, X²-L¹ or a group shown below. X² represents an oxygen, nitrogen, or sulfur atom; and L¹ represents a hydrocarbon group having 1 to 12 carbon atoms, a hetero atom-containing aromatic ring, a hetero atom-containing hydrocarbon group having 1 to 12 carbon atoms. The hetero atom is N, S, O, a halogen atom, or Se. Xa⁻ is the same as W¹⁻ described below; and R^{a} represents a hydrogen atom or a substituent group selected from alkyl, aryl, and substituted or unsubstituted amino groups, and halogen atoms.

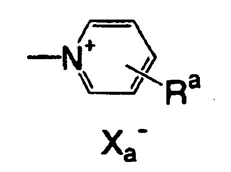

In the formula (a), R¹ and R² each independently represent a hydrocarbon group having 1 to 12 carbon atoms. R¹ and R² each preferably represent a hydrocarbon group having two or more carbon atoms, and R¹ and R² particularly preferably bind to each other, forming a 5- or 6-membered ring, from the point of the storage stability of the recording layer coating solution.

Ar¹ and Ar² each independently represent an aromatic hydrocarbon group that may be substituted. Favorable aromatic hydrocarbon groups include benzene and naphthalene rings. Favorable substituent groups include hydrocarbon groups having 12 or fewer carbon atoms, halogen atoms, and alkoxy groups having 12 or fewer carbon atoms. Y¹ and Y² each independently represent a sulfur atom or a dialkylmethylene group having 12 or fewer carbon atoms. R³ and R⁴ each independently represent a hydrocarbon group having 20 or fewer carbon atoms that may have one or more substituents. Favorable substituent groups include alkoxy groups having 12 or fewer carbon atoms, a carboxyl group, and a sulfo group. R⁵, R⁶, R⁷ and R⁸ each independently represent a hydrogen atom or a hydrocarbon group having 12 or fewer carbon atoms. It is preferably a hydrogen atom, from the availability of raw material. W¹⁻ represents a counter anion. However, when the cyanine dye represented by formula (a) has an anionic substituent group in its structure, there is no need for neutralization of electric charge, and thus, no W¹⁻ is needed. W¹⁻ is preferably a halide, perchlorate, tetrafluoroborate, hexafluorophosphate, or sulfonate ion, particularly preferably, a perchlorate, hexafluorophosphate, or arylsulfonate ion, form the point of the storage stability of the recording-layer coating solution.

When the recording layer has a multilayer structure, the infrared absorbent is preferably added to the upper layer of recording layer or the layer close to it, form the viewpoint of sensitivity. It is possible to make the layer more sensitive and the unexposed region more alkali-resistant, particularly by adding a dye having solubilization-suppressing potential such as cyanine dye together with an alkali-soluble resin having a phenol group to the layer. These infrared absorbents may be added to the lower layer or the upper layer, or alternatively to both upper and lower layers. It is possible to raise the sensitivity further, by adding it to the lower layer. When infrared absorbents are added both to the upper and lower layers, they may be the same as or different from each other.

Alternatively, the infrared absorbent may be added to a layer formed separately from the recording layer. When an additional layer is used, the layer added with the absorbent is preferably close to the recording layer.

The amount of the infrared absorbent to be added is preferably 3 to 50 mass %, more preferably, 5 to 40 mass %, with respect to the total solid content of the recording layer, when a single-layered recording layer is used. When the recording layer has a multilayer structure, the amount of the infrared absorbent added to the upper layer is preferably 0.01 to 50 mass %, more preferably 0.1 to 30 mass %, and particularly preferably 1.0 to 30 mass %, with respect to the total solid content of the upper layer. It is possible to obtain a recording layer favorable in sensitivity and durability, by adjusting the addition amount in the range above. Alternatively when added to the lower layer, the infrared absorbent is added in an amount of preferably 0 to 20 mass %, more preferably 0 to 10 mass %, and particularly preferably 0 to 5 mass %, with respect to the total solid content of the lower layer.

When the infrared absorbent is added to the lower layer, use of an infrared absorbent having solubilization-suppressing potential leads to deterioration in the solubility of the lower layer, but also to possible improvement in the solubility of the lower layer due to the heat generated by the infrared absorbent during infrared laser irradiation, and thus, the compounds added and the addition amounts thereof should be selected, considering the balance thereof. It is difficult to obtain improvement in solubility in the region close to the supporting plate separated by 0.2 to 0.3 µm because of diffusion of the heat generated by irradiation, and thus, addition of an infrared absorbent to the lower layer may lead to deterioration in solubility and also in sensitivity. For that reason, an addition amount that decreases the solubilization speed of the lower layer in developing solution (25 to 30°C) to 30 nm/sec is not favorable, even if it is in the range above.

### 2-4. Other additives

In forming the recording layer, various additives may be added as needed in addition to the components above in the ranges that do not impair the advantageous effects of the invention.

When the recording layer has a multilayer structure, the additives below may be added only to the lower or upper layer of recording layer or both to the upper and lower layers.

### (Development accelerator)

An acid anhydride, phenol or organic acid may be added to the recording layer for improvement in sensitivity.

The acid anhydride is preferably a cyclic acid anhydride, and typical examples thereof include phthalic anhydride, tetrahydrophthalic anhydride, hexahydrophthalic anhydride, 3,6-endoxy-tetrahydrophthalic anhydride, tetrachlorophthalic anhydride, maleic anhydride, chloromaleic anhydride, α-phenylmaleic anhydride, succinic anhydride, pyromellitic anhydride and the like, as described in U.S. Patent No. 4,115,128. Preferable examples of non-cyclic acid anhydrides include acetic anhydride and the like.

Examples of the phenols include bisphenol A, 2,2'-bishydroxydiphenylsulfone, 4,4'-bishydroxydiphenylsulfone, p-nitrophenol, p-ethoxyphenol, 2,4,4'-trihydroxybenzophenone, 2,3,4-trihydroxybenzophenone, 4-hydroxybenzophenone, 4,4',4"- trihydroxytriphenylmethane, 4,4',3",4"-tetrahydroxy-3,5,3',5'-tetramethyltriphenylmethane, and the like.

Examples of the organic acids include the sulfonates, sulfinates, alkyl sulfates, phosphonic acids, phosphoric esters and carboxylic acids described in JP-A Nos. 60-88942 and 2-96755; and typical examples thereof include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluyl acid, 3,4-dimethoxybenzoic acid, phthalic acid, terephthalic acid, 4-cyclohexene-1,2-dicarboxylic acid, erucic acid, lauric acid, n-undecanoic acid, ascorbic acid, and the like.

When the recording layer has a monolayer structure, the content of the acid anhydride, phenol or organic acid is preferably 0.05 to 20 mass %, more preferably 0.1 to 15 mass %, and particularly preferably 0.1 to 10 mass % with respect to the total solid content of the recording layer. When the recording layer has a multilayer structure, the content of the acid anhydride, phenol or and organic acid is preferably 0.05 to 20 mass %, more preferably 0.1 to 15 mass %, and particularly preferably 0.1 to 10 mass %, with respect to the total solid content of the lower or upper layer of recording layer.

### (Surfactant)

The nonionic surfactant described in JP-A Nos. 62-251740 and 3-208514, the amphoteric surfactant described in JP-A Nos. 59-121044 and 4-13149, the siloxane compound described in EP Patent No. 950517, or the fluorine-containing copolymer described in JP-A Nos. 62-170950, 11-288093, and 2003-057820 may be added to the recording layer, for improvement in coatability and stability during processing under the development condition.

When the recording layer has a monolayer structure, the content of the surfactant is preferably 0.01 to 15 mass %, more preferably 0.05 to 5 mass %, and particularly preferably 0.1 to 0.5 mass %, with respect to the total solid content of the recording layer.

When the recording layer has a multilayer structure, the content of the surfactant is preferably 0.01 to 15 mass %, more preferably 0.1 to 5.0 mass %, and still more preferably 0.5 to 2.0 mass %, with respect to the total solid content of the lower or upper layer of recording layer.

### (Printing-out agent/Coloring agent)

A printing-out agent or an image coloring agent such as dye or pigment may be added to the recording layer to obtain a visible image immediately after heating by exposure.

Typical examples of the printing-out agents are combinations of a compound that generates an acid by heating induced by light exposure (photo-induced acid-releasing agent) and an organic dye that can form a salt therewith. Specific examples thereof include combination of the o-naphtoquinonediazide-4-sulfone halide described in JP-A Nos. 50-36209 or 53-8128 and a salt-forming organic dye; and combination of the trihalomethyl compound described in JP-A Nos. 53-36223, 54-74728, 60-3626, 61-143748, 61-151644 or 63-58440 and a salt-forming organic dye. The trihalomethyl compounds include oxazole and triazine compounds, and both of them give a baked-out image superior in storability and definition.

In addition to the salt-forming organic dyes described above, other dyes may be used as the image-coloring agents. Favorable dyes including the salt-forming organic dyes include oil-soluble dyes and basic dyes. Typical examples thereof include Oil Yellow #101, Oil Yellow #103, Oil Pink #312, Oil Green BG, Oil Blue BOS, Oil Blue #603, Oil Black BY, Oil Black BS, and Oil Black T-505 (manufactured by Orient Chemical Industries), Victoria Pure Blue, crystal violet lactone, crystal violet (CI42555), methyl violet (CI42535), ethyl violet, rhodamine B (CI145170B), malachite green (CI42000), methylene blue (CI52015), and the like. The dyes described in JP-A No. 62-293247 are particularly preferable.

When the recording layer has a monolayer structure, the dye is preferably added in an amount of preferably 0.01 to 10 mass %, preferably 0.1 to 3 mass %, with respect to the total solid content of the recording layer.

When the recording layer has a multilayer structure, the dye is added in an amount of 0.01 to 10 mass %, preferably 0.1 to 3 mass %, with respect to the total solid content of the lower or upper layer of recording layer.

### (Plasticizer)

A plasticizer may be added to the recording layer for improvement in the flexibility of the coated film.

Examples thereof include butylphthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, acrylic or methacrylic acid oligomers and polymers, and the like.

When the recording layer has a monolayer structure, the plasticizer is added at a rate of 0.5 to 10 mass %, preferably 1.0 to 5.0 mass %, with respect to the total solid content of the recording layer.

When the recording layer has a multilayer structure, it is added at a rate of 0.5 to 10 mass %, preferably 1.0 to 5.0 mass %, with respect to the total solid content of the lower or upper layer of recording layer.

### (Wax)

A compound lowering the static friction coefficient of the surface may be added to to the top layer of the single- or multi-layered recording layer according to the invention for improvement in resistance to scratch. Typical examples thereof include the compounds having a long-chain alkylcarboxylic ester described in U.S. Patent No. 6,117,913 and Japanese Patent Application Nos. 2001-261627, 2002-032904, and 2002-165584 filed by the applicant, and the like.

When the recording layer has a monolayer structure, the addition amount thereof is preferably 0.1 to 10 mass %, preferably 0.5 to 5.0 mass %, with respect to the total solid matters in the recording layer.

When the recording layer has a multilayer structure, the rate thereof in the top layer of recording layer is preferably 0.1 to 10 mass % and more preferably 0.5 to 5 mass %.

### 2-4. Formation of recording layer

The recording layer of the planographic printing plate precursor may be formed generally by dissolving the above components in at least one solvent to prepare a coating solution for the recording layer, and by applying the coating solution onto a proper support.

Examples of the solvent that may be used herein include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethyl acetamide, N,N-dimethyl formamide, tetramethyl urea, N-methyl pyrrolidone, dimethyl sulfoxide, sulfolane, γ-butyrolactone and toluene, but the invention is not limited thereto. These solvents may be used alone or in combination of two or more thereof.

In the case of the recoding layer has a multilayer structure, it is desirable, in principle, to form the lower layer and the upper layer separately from each other.

Examples of the method for forming the two layers separately include a method that utilizes a difference in solubility in the solvent between the components contained in the lower layer and the components contained in the outermost layer, and a method in which the outermost layer is coated and then quickly dried to remove the solvent.

In order to impart a new function, the lower layer and the upper layer may be partially admixed to such an extent that the effect of the invention remains sufficiently exhibited. The partial admixture can be achieved by controlling the difference in solubility in solvent or controlling the drying rate of the solvent after applying the upper layer.

The concentration of the above components other than the solvent (total solid content including the additives) in the recording layer coating solution to be coated on the support is preferably 1 to 50 ..

There are various possible methods for applying the coating solution onto the support. Examples thereof include bar coater coating, spin coating, spray coating, curtain coating, dip coating, air knife coating, blade coating and roll coating.

In the case of the recording layer has a multilayer structure, in order to prevent the lower layer from being damaged upon coating the upper layer, the coating method is preferably a non-contact coating method. Bar coater coating, which is generally used for a solvent-based coating, despite being a contact method may be used. The bar coater coating is desirably effected by forward rotation in order to prevent damage to the lower layer.

The amount of the components of the recording layer to be applied in the recording layer having a monolayer structure is preferably in a range of 0.3 to 3.0 g/m² and more preferably in a range of 0.5 to 2.5 g/m² after dried.

The amount of the components of the lower layer to be applied in the recording layer having a multilayer structure is preferably in a range of 0.5 to 4.0 g/m² and more preferably in a range of 0.6 to 2.5 g/m² after dried. When the applied amount is 0.5 g/m² or more, printing durability is excellent, and when the applied amount is 4.0 g/m² or less, good image reproducibility and sensitivity can be attained.

Further, the amount of the components of the upper layer to be applied is preferably in a range of 0.05 to 1.0 g/m² and more preferably in a range of 0.08 to 0.7 g/m² after dried. When the applied amount is 0.05 g/m² or more, good developing latitude and resistance to the scratching can be obtained, and when the applied amount is 1.0 g/m² or less, good sensitivity can be obtained.

The total amount of the components of the upper layer and lower layer to be applied is preferably in a range of 0.6 to 4.0 g/m² and more preferably in a range of 0.7 to 2.5 g/m² after dried. When the total amount is 0.6 g/m² or more, good printing durability can be obtained, and when the total amount is 4.0 g/m² or less, good image reproducibility and sensitivity can be obtained.

### 2-5. Support

The support which is used in the planographic printing plate precursors of the invention may be any plate-form product that has necessary strength and endurance and is dimensionally stable. Examples thereof include a paper sheet; a paper sheet on which a plastic (such as polyethylene, polypropylene, or polystyrene) is laminated; a metal plate (such as an aluminum, zinc, or copper plate), a plastic film (such as a cellulose diacetate, cellulose triacetate, cellulose propionate, cellulose lactate, cellulose acetate lactate, cellulose nitrate, polyethylene terephthalate, polyethylene, polystyrene, polypropylene, polycarbonate, or polyvinyl acetal film); and a paper or plastic film on which a metal as described above is laminated or vapor-deposited.

Of these supports, a polyester film or an aluminum plate is preferable in the invention. An aluminum plate is particularly preferable since the plate is good in dimensional stability and relatively inexpensive. Preferable examples of the aluminum plate include a pure aluminum plate, and alloy plates comprising aluminum as the main component and a trace of different elements. A plastic film on which aluminum is laminated or vapor-deposited may be used. Examples of the different elements contained in the aluminum alloy include silicon, iron, manganese, copper, magnesium, chromium, zinc, bismuth, nickel, and titanium. The content by percentage of the different elements in the alloy is at most 10 ..

In the invention, pure aluminum is particularly preferable. However, completely pure aluminum is not easily produced from the viewpoint of metallurgy technology. Thus, aluminum containing a trace of the different elements may be used.

In the aluminum plate as described above, the composition is not specified, any aluminum plate that has been known or used hitherto may be appropriately used. The thickness of the aluminum plate used in the invention is generally about 0.1 to 0.6 mm, preferably 0.15 to 0.4 mm, and more preferably 0.2 to 0.3 mm.

The aluminum plate may be subjected to a surface treatment, such as a surface roughening treatment and an anodic oxidation treatment, if necessary. The surface treatment will be described below.

Before the surface of the aluminum plate is roughened, the plate is subjected to degreasing treatment with a surfactant, an organic solvent, an aqueous alkaline solution or the like if desired, in order to remove rolling oil on the surface. The roughening treatment of the aluminum plate surface is performed by any one of various methods, for example, by a mechanically surface-roughening method, or a method of dissolving and roughening the surface electrochemically, or a method of dissolving the surface selectively in a chemical manner.

The mechanically surface-roughening method which can be used may be a known method, such as a ball polishing method, a brush polishing method, a blast polishing method or a buff polishing method. The electrochemically surface-roughening method may be a method of performing surface-roughening in a hydrochloric acid or nitric acid electrolyte by use of alternating current or direct current. As disclosed in JP-A No. 54-63902, a combination of the two may be used.

The aluminum plate the surface of which is roughened as described above is subjected to alkali-etching treatment and neutralizing treatment if necessary. Thereafter, the aluminum plate is subjected to anodizing treatment if desired, in order to improve the water holding ability or wear resistance of the surface. The electrolyte used in the anodizing treatment of the aluminum plate is any one selected from various electrolytes which can make a porous oxide film. There is generally used sulfuric acid, phosphoric acid, oxalic acid, chromic acid, or a mixed acid thereof. The concentration of the electrolyte may be appropriately decided depending on the kind of the electrolyte.

Conditions for the anodizing treatment cannot be specified without reservation since the conditions vary depending on the electrolyte used. The following conditions are generally suitable: an electrolyte concentration of 1 to 80 . , a solution temperature of 5 to 70°C, a current density of 5 to 60 A/dm², a voltage of 1 to 100 V, and an electrolyzing time of 10 seconds to 5 minutes. If the amount of the anodic oxide film is less than 1.0 g/m², the printing durability is insufficient or non-image areas of the planographic printing plate are easily injured so that the so-called "injury stains", resulting from ink adhering to injured portions at the time of printing, are easily generated.

If necessary, the aluminum surface is subjected to treatment for hydrophilicity after the anodizing treatment.

The treatment for hydrophilicity which can be used in the invention may be an alkali metal silicate (for example, aqueous sodium silicate solution) method, as disclosed in U.S. Patent Nos. 2,714,066, 3,181,461, 3,280,734, and 3,902,734. In this method, the support is subjected to immersing treatment or electrolyzing treatment with aqueous sodium silicate solution. Besides, there may be used a method of treating the support with potassium fluorozirconate disclosed in JP-B No. 36-22063 or with polyvinyl phosphonic acid, as disclosed in U.S. Patent Nos. 3,276,868, 4,153,461, and 4,689,272.

### 3. Organic undercoating layer

The planographic printing plate precursor may be provided with an organic undercoat layer between the support and the recording layer as need.

As components for the organic undercoat layer, various organic compounds may be used. Examples thereof include carboxymethylcellulose, dextrin, gum arabic, phosphonic acids having an amino group such as 2-aminoethylphosphonic acid, organic phosphonic acids such as phenylphosphonic acid, naphthylphosphonic acid, alkylphosphonic acid, glycerophosphonic acid, methylenediphosphonic acid and ethylenediphosphonic acid, each of which may have a substituent, organic phosphoric acids such as phenylphosphoric acid, naphthylphosphoric acid, alkylphosphoric acid and glycerophosphoric acid, each of which may have a substituent, organic phosphinic acids such as phenylphosphinic acid, naphthylphosphinic acid, alkylphosphinic acid, and glycerophosphinic acid, each of which may have a substituent, amino acids such as glycine and β-alanine, and hydrochlorides of amines having a hydroxy group, such as hydrochloride of triethanolamine. These may be used in a mixture form.

Also, the organic undercoat layer preferably contains a compound having an onium group. The compound having an onium salt is described in detail in each publication of JP-A Nos. 2000-10292, 2000-108538 and 2000-241962.

Also, besides the above compounds, at least one compound selected from polymers having a structural unit represented by a poly(p-vinylbenzoic acid) may be used. Specific examples thereof include copolymers of a p-vinylbenzoic acid and a vinylbenzyltriethylammonium chloride and copolymers of a p-vinylbenzoic acid and a vinylbenzyltrimethylammonium salt.

This organic undercoat layer can be formed by the following method: a method of dissolving the above-mentioned organic compound into water, an organic solvent such as methanol, ethanol or methyl ethyl ketone, or a mixed solvent thereof to prepare a solution, applying the solution onto an aluminum plate, and drying the solution to form the undercoat layer; or a method of dissolving the above-mentioned organic compound into water, an organic solvent such as methanol, ethanol or methyl ethyl ketone, or a mixed solvent thereof to prepare a solution, dipping an aluminum plate into the solution to cause the plate to adsorb the organic compound, washing the plate with water or the like, and then drying the plate to form the organic undercoat layer. In the former method, the solution of the organic compound having a concentration of 0.005 to 10 mass % an be applied by various methods. In the latter method, the concentration of the organic compound in the solution is from 0.01 to 20 mass %, preferably from 0.05 to 5mass %, the dipping temperature is 20 to 90°C, preferably 25 to 50°C, and the dipping time is 0.1 second to 20 minutes, preferably 2 seconds to 1 minute. The pH of the solution used in this method can be adjusted into the range of 1 to 12 with a basic material such as ammonia, triethylamine or potassium hydroxide, or an acidic material such as hydrochloric acid or phosphoric acid. A yellow dye can be added to the solution in order to improve the reproducibility of the tone of the image recording material.

The coated amount of the organic undercoat layer is appropriately 2 to 200 mg/m², and preferably 5 to 100 mg/m², in terms of obtaining sufficient printing durability.

The infrared sensitive planographic printing plate precursor thus produced is exposed imagewise and then subjected to a developing treatment.

### 4. Plate making

The planographic printing plate precursor of the invention forms an image by a heat. Specifically, a direct image recording by a heat recording head or the like, scanning exposure by an infrared laser, a high illumination flash exposure such as xenon discharge lamp, an infrared lamp exposure, and the like may be used. It is preferable an exposure by a solid infrared laser with a high output such as a semiconductor laser, YAG laser, and the like, which emit infrared light having a wavelength of 700 to 1200 nm.

The exposed planographic printing plate precursor makes to the printing plate by a developing treatment and after-treatment with a finisher or protective gum. In these treatments, processing machines such as the known automatic processor, or the like may be used.

Treating agents used in the developing treatment and after-treatment for the planographic printing plate precursor may be selected from any known treating agents.

As the developing solution, it is preferred to use developing solutions having pH of 9.0 to 14.0, and more preferably, pH of 12.0 to 13.5. As the developing solution, an aqueous alkaline solution that has been conventionally known may be used. Among these aqueous alkaline solution, preferable examples of the developing solutions include a developing solution containing an alkaline silicate as a base or alkaline silicate obtained by mixing a base with a silicon compound, an aqueous solution which has a pH of 12 or more and is the so-called "silicate developing solution" that has been conventionally known, and a developing solution that is the so-called "non-silicate developing solution", which does not comprise any alkaline silicate but comprises a non-reducing sugar (organic compound having a buffer action) and a base, as disclosed in JP-A No. 8-305039, JP-A No. 11-109637, or the like.

Further, the developing solution may contain an anionic surfactant and/or an amphoteric surfactant from the viewpoint of developing promotion and prevention of the slag generation.

When the planographic printing plate precursor is subjected to burning treatment, it is preferred to use a burning conditioner, a burning processor, or the like according to the conventionally known method.

The planographic printing plate obtained by the treatment described above is applied on offset printer or the like for the multi printing.

Hereinafter, the present invention will be described with reference to examples but is not limited thereto.

### Examples

### Examples 1 to 15, and Comparative Example 1

### 1. Preparation of support

### <Aluminum plate>

Molten aluminum was prepared by using an aluminum alloy in a composition (consisting of Al, Si: 0.06 mass %, Fe: 0.30 mass %, Cu: 0.026 mass %, Mn: 0.001 mass %, Mg: 0.001 mass %, Zn: 0.001 mass %, Ti: 0.02 mass %, and unavoidable impurities); and the molten aluminum was filtered and molded into ingots having a thickness of 500 mm and a width of 1,200 mm by DC casting. The surface of the ingot was scraped to an average depth of 10 mm by a surface grinder, and the ingot was heated consistently at 550°C for approximately 5 hours, and hot-rolled into a rolled plate having a thickness of 2.7 mm after it is cooled to a temperature of 400°C. The plate was heat-treated additionally at 500°C in a continuous annealing machine, and cold-rolled into a JIS1050 aluminum plate having a thickness of 0.24 mm. The width and the length of the average crystal grain in the aluminum plate obtained were respectively 50 µm and 300 µm. After the aluminum plate was cut to a width of 1,030 mm, it was subjected to the following surface treatment.

### <Surface treatment>

As surface treatment, the following treatments (a) to (k) were continuously conducted. After each of the treatments and water washing, liquid on the plate was removed with nip rollers.

### (a) Mechanical surface-roughening treatment

While supplying a suspension (specific gravity: 1.12) of an abrasive agent (pumice) in water, as an abrading slurry, onto a surface of the aluminum plate, the surface was subjected to mechanical surface-roughening treatment with rotating roller-form nylon brushes. The average grain size of the abrasive agent was 30 µm. The maximum grain size was 100 µm. The material of the nylon brushes was 6,10-nylon, the bristle length thereof was 45 mm, and the bristle diameter thereof was 0.3 mm. The nylon brushes were each obtained by making holes in a stainless steel cylinder having a diameter of 300 mm and then planting bristles densely therein. The number of the rotating brushes used was three. The distance between the two supporting rollers (diameter: 200 mm) under each of the brushes was 300 mm. Each of the brush rollers was pushed against the aluminum plate until the load of a driving motor for rotating the brush became 7 kW larger than the load before the brush roller was pushed against the aluminum plate. The rotating direction of the brush was the same as the moving direction of the aluminum plate. The speed of rotation of the brush was 200 rpm.

### (b) Alkali etching treatment

A 70°C aqueous solution having a NaOH (caustic soda) concentration of 2.6mass % and an aluminum ion concentration of 6.5 mass % was sprayed onto the aluminum plate obtained as described above to etch the aluminum plate, thereby dissolving 10 g/m² of the aluminum plate. Thereafter, the aluminum plate was washed with sprayed water.

### (c) Desmut treatment

The aluminum plate was subjected to desmut treatment with a 30°C aqueous solution having a nitric acid concentration of 1 mass % (and containing 0.5 mass % of aluminum ions), which was sprayed, and then washed with sprayed water. The aqueous nitric acid solution used in the desmut treatment was waste liquid from a process of conducting electrochemical surface-roughening treatment using alternating current in an aqueous nitric acid solution.

### (d) Electrochemical surface-roughening treatment

Alternating voltage having a frequency of 60 Hz was used to conduct electrochemical surface-roughening treatment continuously. The electrolyte used at this time was a 10.5 g/L solution of nitric acid in water (containing 5 g/L of aluminum ions and 0.007mass % of ammonium ions), and the temperature thereof was 50°C. The time TP until the current value was raised from zero to a peak was 0.8 msec, and the duty ratio of the current was 1:1. The trapezoidal wave alternating current was used, and a carbon electrode was set as a counter electrode to conduct the electrochemical surface-roughening treatment. Ferrite was used as an auxiliary anode. An electrolytic bath used is a radial cell type bath.

The density of the current was 30 A/dm² when the current was at the peak. The total electricity quantity when the aluminum plate functioned as an anode was 220 C/dm². 5% of the current sent from the power source was caused to flow into the auxiliary anode. Thereafter, the aluminum plate was washed with sprayed water.

### (e) Alkali etching treatment

An aqueous solution having a caustic soda concentration of 26 mass % and an aluminum ion concentration of 6.5 mass % was used for spray to etch the aluminum plate at 32°C so as to dissolve 0.50 g/m² of the aluminum plate, thereby removing smut components made mainly of aluminum hydroxide and generated when the alternating current was used to conduct the electrochemical surface-roughening treatment in the previous process, and further dissolving edges of formed pits so as to be made smooth. Thereafter, the aluminum plate was washed with sprayed water.

### (f) Desmut treatment

The aluminum plate was subjected to desmut treatment with a 30°C aqueous solution having a sulfuric acid concentration of 15mass % (and containing 4.5 mass % of aluminum ions), which solution was sprayed. The aluminum plate was then washed with sprayed water. The aqueous nitric acid solution used in the desmut treatment was waste liquid from the process of conducting the electrochemical surface-roughening treatment using the alternating current in the aqueous nitric acid solution.

### (g) Electrochemical surface-roughening treatment

Alternating voltage having a frequency of 60 Hz was used to conduct electrochemical surface-roughening treatment continuously. The electrolyte used at this time was a 5.0 g/L solution of hydrochloric acid in water (containing 5 g/L of aluminum ions), and the temperature thereof was 35°C. The time TP until the current value was raised from zero to a peak was 0.8 msec, and the duty ratio of the current was 1:1. The trapezoidal wave alternating current was used, and a carbon electrode was set as a counter electrode to conduct the electrochemical surface-roughening treatment. Ferrite was used as an auxiliary anode. The electrolyte bath used was a radial cell type bath.

The density of the current was 25 A/dm² when the current was at the peak. The total electricity quantity when the aluminum plate functioned as an anode was 50 C/dm². Thereafter, the aluminum plate was washed with sprayed water.

### (h) Alkali etching treatment

An aqueous solution having a caustic soda concentration of 26 mass % and an aluminum ion concentration of 6.5 mass % was sprayed onto the aluminum plate to etch the plate at 32°C so as to dissolve 0.10 g/m² of the plate, thereby removing smut components made mainly of aluminum hydroxide and generated when the alternating current was used to conduct the electrochemical surface-roughening treatment in the previous process, and further dissolving edges of formed pits so as to be made smooth. Thereafter, the aluminum plate was washed with sprayed water.

### (i) Desmut treatment

The aluminum plate was subjected to desmut treatment with a 60°C aqueous solution having a sulfuric acid concentration of 25 mass % (and containing 0.5 mass % of aluminum ions), which solution was sprayed. The aluminum plate was then washed with sprayed water.

### (j) Anodizing treatment

An anodizing machine in two stage power feeding electrolysis (the length of each of first and second electrolyzing sections being 6 m, the length of each of first and second power feeding sections being 3 m, and the length of each of first and second power feeding electrodes being 2.4 m) was used to conduct anodizing treatment. Sulfuric acid was used in the electrolytes supplied to the first and second electrolyzing sections. The electrolytes each had a sulfuric acid concentration of 50 g/L (and contained 0.5mass % of aluminum ions), and the temperature thereof was 20°C. Thereafter, the plate was washed with sprayed water. The density of ultimately formed oxide film was 2.7 g/m².

### (k) Treatment with alkali metal silicate

The aluminum support obtained by the anodizing treatment was immersed into a treatment tank containing a 30°C aqueous solution of #3 sodium silicate (concentration of sodium silicate: 1mass %) for 10 seconds, so as to subject the support to treatment with the alkali metal silicate (silicate treatment). Thereafter, the support was washed with sprayed water. In this way, a support whose surface had been made hydrophilic with silicate was obtained for an infrared sensitive planographic printing plate precursor.

### 2. Formation of back coat layer (organic polymer layer)

Regarding Examples 1 to 15, an organic polymer layer was formed on the surface of the above-obtained support (back surface) opposite to the surface on which a recording layer was formed, by preparing a backcoat solution having the following composition, applying the backcoat solution onto the support while varying the coating amount by controlling the wet amount thereof with a bar coater so that a thickness of the organic polymer layer after drying became 2µm, and then, heating and drying the coated layer at 140°C for 3 minutes.

Regarding Comparative Example 1, a back coating layer was not formed.

### <Back coat solution>

- Organic polymer (compound described in Table 1) 10 g
- Crosslinking agent for organic polymer amount shown in Table 1
   (compound shown in Table 1) amount shown in Table 1
- Specific polymer particle (shown in Table 1) amount shown in Table 1
- Surfactant
   (fluorochemical surfactant B, having the following structure) g 0.05
- Methyl ethyl ketone 100 g

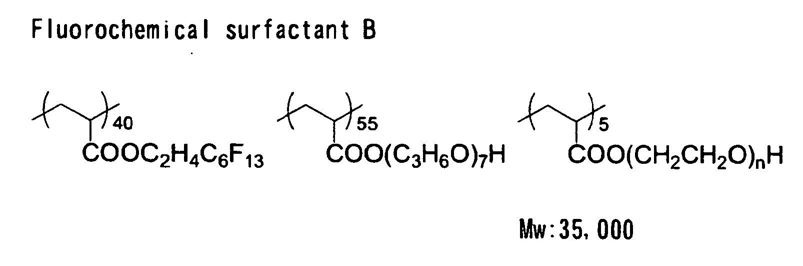

**Table 1**

| | Organic polymer | | | Crosslinking agent for organic polymer | | Specific polymer particle | | | Occurrence of scratching during transportation | Occurrence of schrating during handling on an aoutoloader |
|---|---|---|---|---|---|---|---|---|---|---|
| | Kind of organic polymer | | Epoxy equivalent (g/eq) | Kind of crosslinking agent | Addition amount (g) | Kind *3) | Average particle diameter (ng) | Addition amount (g) | | |
| Example 1 | | Epicoat 828 *1) | About 190 | Triethylenetetramine | 1.7 | ARX-806 | 8 | 1 | A | A |
| Example 2 | | Epicoat 1001 *1) | About 480 | Triethylenetetramine | 0.7 | ARX-806 | 8 | 1 | A | A |
| Example 3 | | Epicoat 1004 *1) | About 925 | Triethylenetetramine | 0.35 | ARX-806 | 8 | 1 | A | A |
| Example 4 | | Epicoat 1001 *1) | About 480 | Triethylenetetramine | 0.7 | ARX-806 | 8 | 0.5 | A | A |
| Example 5 | | Epicoat 1001 *1) | About 480 | Triethylenetetramine | 0.7 | ARX-806 | 8 | 3 | A | A |
| Example 6 | | Epicoat 1001 *1) | About 480 | Triethylenetetramine | 0.7 | ARX-15 | 15 | 1 | A | A |
| Example 7 | Epoxy resin | Epicoat 1001 *1) | About 480 | Triethylenetetramine | 0.7 | ARX-30 | 30 | 1 | A | A |
| Example 8 | | Epicoat 1001 *1) | About 480 | Triethylenetetramine | 0.7 | MBX-15SS | 15 | 1 | A | A |
| Example 9 | | Epicoat 1001 *1) | About 480 | Triethylenetetramine | 0.7 | MB30X-5 | 5 | 1 | A | A |
| Example 10 | | Epicoat 1001 *1) | About 480 | Triethylenetetramine | 0.7 | ARX-5 | 5 | 1 | A | A |
| Example 11 | | Epicoat 1001 *1) | About 480 | Triethylenetetramine | 0.7 | MBX-5 | 5 | 1 | A | A |
| Example 12 | | Epicoat 1001 *1) | About 480 | Triethylenetetramine | 0.7 | MB30X-5 | 15 | 1 | A | A |
| Example 13 | | Epicoat 1001 *1) | About 480 | Triethylenetetramine | 0.7 | SBX-12 | 12 | 1 | A | A |
| Example 14 | Resol resin | Sumilite Resin PR-9480 *2) | - | P-toluenesulfonic acid | 0.5 | ARX-806 | 8 | 1 | A | A |
| Example 15 | | Sumilite Resin PR-51904 *2) | - | P-toluenesulfonic acid | 0.5 | ARX-806 | 8 | 1 | A | A |
| Comparative Example 1 | None | | - | - | - | None | - | - | B | B |

| | | | | | | | | | | |
|---|---|---|---|---|---|---|---|---|---|---|
| * 1) Epoxy resin manufactured by Japan Epoxy Resins Co., Ltd. *2) Resol resin manufactured by Sumitomo Bakelite Co., Ltd. *3) All product name of Techpolymer Series manufactured by Sekisui Plastics Co., Ltd. | | | | | | | | | | |

### 3. Formation of organic undercoating layer

On the other side of support on which the organic polymer layer was formed, and whose surface was conducted the surface treatment, an undercoat solution having the following composition was applied using a bar coater, and then the resultant layer was dried at 80°C for 15 seconds to form a undercoat layer. The coated amount after drying was 18 mg/m²

### <Organic undercoating solution>

- Polymer having a structure described bellow 0.3 g
- Methanol 100 g

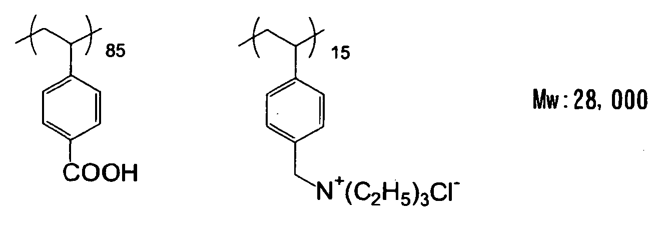

### 4. Formation of recording layer

A lower layer coating solution having the following composition was applied onto an aluminum support with the organic undercoat layer such that the dry coating amount was 0.85 g/m² by using a bar coater. Then, the coated layer was dried at 160°C for 44 seconds, and then immediately cooled with cool air at 17 to 20°C until the temperature of the support was 35°C to form a lower layer.

Thereafter, an upper layer coating solution having the following composition was applied onto the lower layer such that the dry coating amount was 0.22 g/m² by using a bar coater, then dried at 148°C for 25 seconds and then cooled gradually with cool air at 20 to 26°C, to form an upper layer.

### <Composition of coating solution for lower layer>

- N-(4-aminosulfonylphenyl)methacrylamide/acrylonitrile/ methyl methacrylate
   (36/34/30 mass%: weight average molecular weight 50,000, acid value 2.65) 2.1 g
- m,p-cresol Novolak
   (m/p ratio = 6/4, weight average molecular weight 4500, containing 0.8 mass % of unreacted cresol, Tg: 75°C) 0.1 g
- Cyanine dye A (the structure described below) 0.13 g

- 4,4'-Bishydroxyphenylsulfone 0.13 g
- Tetrahydrophthalic anhydride 0.19 g
- p-toluenesulfonic acid 0.008 g
- 3-Methoxy-4-diazodiphenylamine hexafluorophosphate 0.032 g
- Ethyl Violet in which counter ion was changed to 6-hydroxy-2-naphthalenesulfonic acid 0.078 g
- Fluorochemical surfactant B (the above structure) 0.007 g
- Methyl ethyl ketone 25.0 g
- 1-Methoxy-2-propanol 13.0 g
- γ-butyrolactone 13.0 g

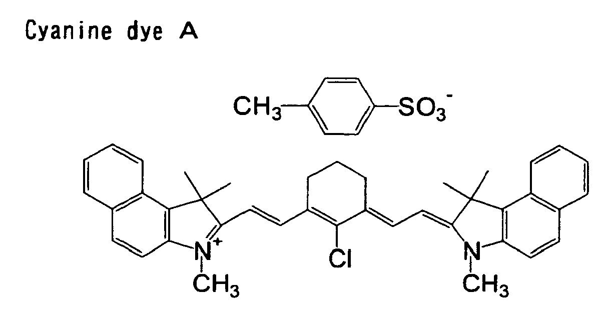

### <Composition of coating solution for upper layer>

- Phenol/m-cresol/p-cresol Novolak
   (molar ratio = 5/3/2, weight average molecular weight: 5,000, containing 1.2 mass % of unreacted cresol, Tg: 70°C) 0.35 g
- Acryl-based resin C (the structure described below) 0.042 g
- Cyanine dye A (the above structure) 0.018 g
- Ammonium compound D (the structure described below) 0.019 g
- Sulfonium compound G (the structure described below) 0.004 g
- Fluorochemical surfactant B (the above structure) 0.032 g
- Fluorochemical surfactant E (the structure described below) 0.0045 g
- Fluorine polymer F (the structure described below) 0.0033 g
- Methyl ethyl ketone 10.0 g
- 1-Methoxy-2-propanol 20.0 g

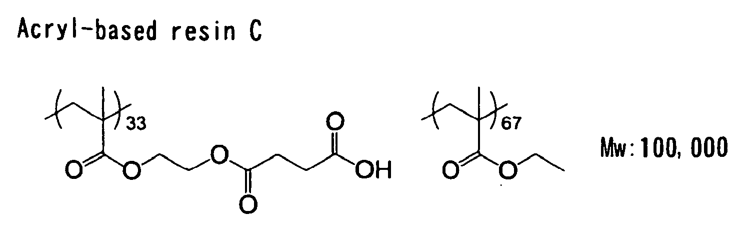

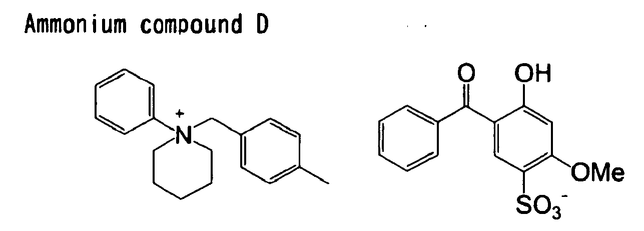

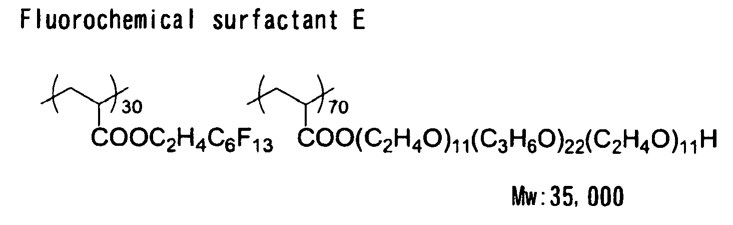

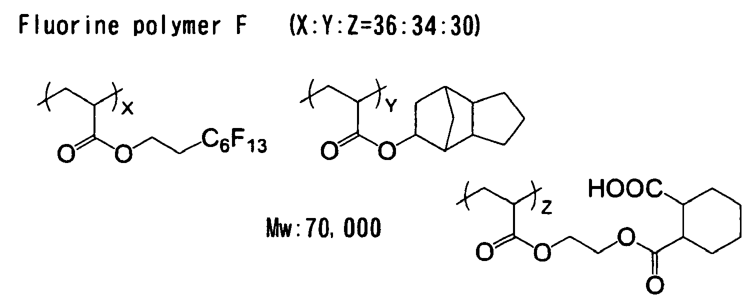

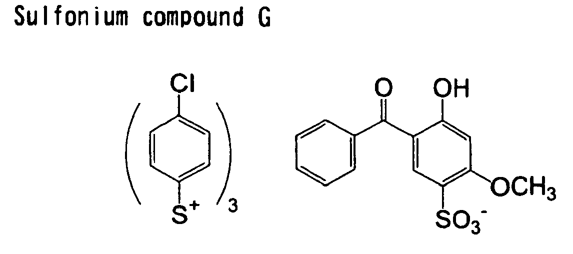

### 5. Evaluation

Each of the resulted infrared-sensitive planographic printing plate precursors of the Examples and Comparative Examples were evaluated in the following terms: (1) occurrence of scratching during transportation, and (2) occurrence of scratching during handling on an autoloader.

### 5-1. Occurrence of scratching during transportation

Each of the resulted infrared-sensitive planographic printing plate precursors were cut into 1030 mm x 800 mm-sized pieces and 30 pieces of them were stacked without interleaf sheets. The top and bottom ends of each stack were covered by a piece of cardboard having thickness of 0.5 mm. The cardboard pieces were taped at four corners and then the stacks were wrapped with aluminum kraft paper. The stacks were further wrapped with corrugated board and taped to provide packages with no interleaf sheets. The packages were carried on pallets and transported 2000 km on a lorry and then unpacked. The unpacked infrared-sensitive planographic printing plate precursors were developed in an automatic developing machine, LP-940HII (manufactured by Fuji Photo Film Co., Ltd.) with a developer, DT-2 (manufactured by Fuji Photo Film Co., Ltd., diluted to 1:8). The developing temperature was 32°C, and the developing time was 12 seconds. The electric conductivity of the developing solution was 43 mS/cm. The resulted planographic printing plates were evaluated by observing white clarity appeared in image areas caused by transportation.

Evaluation criteria were: (A) no white clarity was observed, and (B) white clarity was observed. The results are shown in Table 1.

### 5-2. Occurrence of scratching during handling on an autoloader

The resulted planographic printing plate precursors were cut into the same size as above and 10 pieces of them were loaded in a cassette of a single autoloader, LuxelT-9800CTP without interleaf sheets. The printing plate precursors were automatically fed and mounted on a drum. The printing plate precursors were then output without being exposed. The printing plate precursors were developed in the automatic developing machine, LP-940HII (manufactured by Fuji Photo Film Co., Ltd.) with the developer, DT-2 (manufactured by Fuji Photo Film Co., Ltd., diluted to 1:8) and a finisher, FG-1 (manufactured by Fuji Photo Film Co., Ltd., diluted to 1:1). The developing temperature was 32°C, and the developing time was 12 seconds. The electric conductivity of the developing solution was 43 mS/cm. The resulted planographic printing plates were evaluated by observing scratching caused by loading and unloading.

Evaluation criteria were: (A) no scratching was observed, and (B) scratching was observed. The results are shown in Table 1.

As shown in Table 1, the infrared sensitive planographic printing plates of Examples having an organic polymer layer containing a specific polymer particle are excellent in scratch resistance even when they are stacked and packaged without interleaf sheets.

In addition, each 1500 of each of infrared sensitive planographic printing plates of Examples were stacked without a interleaf sheet, an iron caul was placed above and under the stack, and this was allowed to stand in a storehouse for one month in summer (July) in the bolted mass transportation state. Thereafter, a bolt was released, the presence or the absence of adherability between planographic printing plate precursors were confirmed, and no adhesion between plates was observed in all planographic printing plate precursors of Examples 1 to 15.

## Claims

1. An infrared sensitive planographic printing plate precursor comprising:
a support;
a recording layer disposed on or above a surface of the support and capable of forming an image by infrared irradiation, the recording layer comprising a water-insoluble and alkali-soluble resin and an infrared absorbent; and
an organic polymer layer disposed on or above another surface of the support, the organic polymer layer comprising a crosslinked polymer particle having a number-average particle diameter of 1 to 100µm, wherein the organic polymer layer contains at least one organic polymer selected from an epoxy resin and a resol resin.

2. The infrared sensitive planographic printing plate precursor of claim 1, wherein the content of the organic polymer contained in the organic polymer layer is in a range of 99.7 to 40 mass % with respect to the total solid content of the organic polymer layer.

3. The infrared sensitive planographic printing plate precursor of claim 1 or 2, wherein the organic polymer layer further contains a crosslinking agent.

4. The infrared sensitive planographic printing plate precursor of claim 3, wherein the content of the crosslinking agent contained in the organic polymer layer is in a range of 0.3 to 30 mass % with respect to the total solid content of the organic polymer layer.

5. The infrared sensitive planographic printing plate precursor of any one of claims 1 to 4, wherein the content of the crosslinked polymer particle is in a range of 0.3 to 40 mass % with respect to the total mass of the polymer layer.

6. The infrared sensitive planographic printing plate precursor of any one of claims 1 to 5, wherein the thickness of the organic polymer layer is in a range of 0.05 to 50µm.

7. The infrared sensitive planographic printing plate precursor of any one of claims 1 to 6, wherein a dynamic friction coefficient of a surface of the organic polymer layer is in a range of 0.38 to 1.2.

## Patentansprüche

1. Infrarotempfindlicher Flachdruckplatten-Vorläufer, umfassend:
einen Träger,
eine Aufzeichnungsschicht, die auf oder über einer Oberfläche des Trägers angeordnet ist und in der Lage ist, durch Infrarotbestrahlung ein Bild zu erzeugen, wobei die Aufzeichnungsschicht ein wasserunlösliches und alkalilösliches Harz und einen Infrarotabsorber umfaßt, und
eine organische Polymerschicht, die auf oder über einer anderen Oberfläche des Trägers angeordnet ist, wobei die organische Polymerschicht vernetzte Polymerpartikel mit einem zahlengemittelten Partikeldurchmesser von 1 bis 100 µm umfaßt, wobei die organische Polymerschicht zumindest ein organisches Polymer umfaßt, das aus Epoxyharzen und Resolharzen ausgewählt ist.

2. Infrarotempfindlicher Flachdruckplatten-Vorläufer gemäß Anspruch 1, worin der Gehalt des organischen Polymers, das in der organischen Polymerschicht enthalten ist, im Bereich von 99,7 bis 40 Massen%, in Bezug auf den Gesamtfeststoffgehalt der organischen Polymerschicht, liegt.

3. Infrarotempfindlicher Flachdruckplatten-Vorläufer gemäß Anspruch 1 oder 2, worin die organische Polymerschicht ferner ein Vernetzungsmittel umfaßt.

4. Infrarotempfindlicher Flachdruckplatten-Vorläufer gemäß Anspruch 3, worin der Gehalt des Vernetzungsmittels, das in der organischen Polymerschicht enthalten ist, im Bereich von 0,3 bis 30 Massen%, in Bezug auf den Gesamtfeststoffgehalt der organischen Polymerschicht, liegt.

5. Infrarotempfindlicher Flachdruckplatten-Vorläufer gemäß irgendeinem der Ansprüche 1 bis 4, worin der Gehalt der vernetzten Polymerpartikel im Bereich von 0,3 bis 40 Massen%, in Bezug auf die Gesamtmasse der Polymerschicht, liegt.

6. Infrarotempfindlicher Flachdruckplatten-Vorläufer gemäß irgendeinem der Ansprüche 1 bis 5, worin die Dicke der organischen Polymerschicht im Bereich von 0,05 bis 50 µm liegt.

7. Infrarotempfindlicher Flachdruckplatten-Vorläufer gemäß irgendeinem der Ansprüche 1 bis 6, worin der dynamische Reibungskoeffizient einer Oberfläche der organischen Polymerschicht im Bereich von 0,38 bis 1,2 liegt.

## Revendications

1. Précurseur de plaque d'impression planographique sensible aux infrarouges, comprenant :
un support ;
une couche d'enregistrement disposée sur ou au-dessus d'une surface du support et capable de former une image par rayonnement infrarouge, la couche d'enregistrement comprenant une résine insoluble dans l'eau et soluble en milieu alcalin et un agent absorbant l'infrarouge ;
une couche de polymère organique, disposée sur ou au-dessus d'une autre surface du support, la couche de polymère organique comprenant une particule de polymère réticulé ayant un diamètre moyen en nombre de particule de 1 à 100 µm, où le couche de polymère organique contient au moins un polymère organique choisi parmi une résine époxy et une résine résol.

2. Précurseur de plaque d'impression planographique sensible aux infrarouges, selon la revendication 1, dans lequel la teneur en polymère organique présent dans la couche de polymère organique se situe dans l'intervalle allant de 99,7 à 40% en masse par rapport à la teneur totale en matières solides de la couche de polymère organique.

3. Précurseur de plaque d'impression planographique sensible aux infrarouges, selon la revendication 1 ou 2, dans lequel la couche de polymère organique contient en outre, un agent de réticulation.

4. Précurseur de plaque d'impression planographique sensible aux infrarouges, selon la revendication 3, dans lequel la teneur en agent de réticulation présent dans la couche de polymère organique se situe dans l'intervalle allant de 0,3 à 30% en masse par rapport à la teneur totale en matières solides de la couche de polymère organique.

5. Précurseur de plaque d'impression planographique sensible aux infrarouges, selon l'une quelconque des revendications 1 à 4, dans lequel la teneur en particules de polymère réticulé se situe dans l'intervalle allant de 0,3 à 40% en masse par rapport à la masse totale de la couche de polymère.

6. Précurseur de plaque d'impression planographique sensible aux infrarouges, selon l'une quelconque des revendications 1 à 5, dans lequel l'épaisseur de la couche de polymère organique se situe dans l'intervalle allant de 0,05 à 50 µm.

7. Précurseur de plaque d'impression planographique sensible aux infrarouges, selon l'une quelconque des revendications 1 à 6, dans lequel un coefficient de frottement dynamique d'une surface de la couche du polymère organique se situe dans l'intervalle allant de 0,38 à 1,2.
